# EUROPEAN PATENT APPLICATION

(11) **EP 4 761 012 A1**
(43) Date of publication of application: **17.06.2026**
(21) Application number: 24899201.8
(22) Date of filing: 21.06.2024
(51) Int. Cl.: H01S 5/02345

(54) **LIGHT-EMITTING APPARATUS AND LASER PROJECTION DEVICE**

(30) Priority: 08.12.2023 CN 202311683844; 08.12.2023 CN 202323356173 U
(71) Applicant: Hisense Laser Display Co., Ltd., Huangdao District Qingdao, Shandong 266555 (CN)
(72) Inventor: DUAN, Chongyao, Qingdao, Shandong 266555 (CN); ZHANG, Minglong, Qingdao, Shandong 266555 (CN); ZHOU, Zinan, Qingdao, Shandong 266555 (CN); TIAN, Youliang, Qingdao, Shandong 266555 (CN)
(74) Representative: Casalonga
(86) International application number: PCT/CN2024/100790
(87) International publication number: WO 2025/118550

(57) **Abstract**

A light-emitting apparatus and a laser projection device, relating to the technical field of lasers. **In** the light-emitting apparatus, a mounting substrate comprises a connecting pattern, electrical connection portions, and an in-board interconnection region, the electrical connection portions are located on the surface of the mounting substrate, and the electrical connection portions are electrically connected to the connecting pattern by means of the in-board interconnection region; and a light-emitting unit comprises a packaging tube housing and at least two types of laser chip groups having different light emitting colors and arranged in the packaging tube housing, the light-emitting unit is fixed to the mounting substrate, and the light-emitting unit is electrically connected to the connecting pattern. A plurality of groups of electrical connection portions are provided, and correspond one-to-one to the at least two types of laser chip groups, each group of electrical connection portions comprises a positive electrode connection portion and a negative electrode connection portion, the positive electrode connection portion is connected to a positive electrode of a corresponding color of laser chip group, and the negative electrode connection portion is connected to a negative electrode of a corresponding color of laser chip group. The light-emitting apparatus solves the problem that the number of driving circuits is increased along with an increase of the number of lasers, effectively improves the working efficiency of the driving circuits, reduces costs, and facilitates miniaturization design.

## Description

The present disclosure claims priority to Chinese Patent Application No. 202311683844.6, filed on December 8, 2023, entitled "a light-emitting apparatus and a laser projection device"; and priority to Chinese Patent Application No. 202323356173.0, filed on December 8, 2023, entitled "a light-emitting apparatus and a laser projection device", the contents of which are incorporated herein by reference in its entirety.

### TECHNICAL FIELD

The present disclosure relates to the field of laser technologies, and in particular, to a light-emitting apparatus and a laser projection device.

### BACKGROUND

Laser projectors are widely used due to their high color saturation and high brightness, which is conducive to enhancing the viewing experience for users. A laser projector includes a light-emitting apparatus (i.e., a laser device) and a driving circuit for driving the laser device to emit laser beams. The laser device includes a plurality of laser chips with different light-emitting colors. Generally, in order to reduce wiring and save space, the plurality of laser chips with different light-emitting colors in the laser device use a common anode or common cathode wiring manner.

However, either common anode or common cathode wiring scheme for laser chips has the problem that the number of driving circuits increases with the number of laser devices, which not only affects the working efficiency of the driving circuit, but also leads to an increase in cost.

### SUMMARY

Exemplary embodiments of the present disclosure provide a light-emitting apparatus and a laser projection device to solve the problem that the number of laser devices used is limited by the driving circuit. While increasing the number of laser devices, the number of driving circuits will not increase, which may effectively improve the working efficiency of the driving circuit and reduce costs.

The technical solutions provided in the present disclosure are as follows.

In a first aspect, embodiments of the present disclosure provide a light-emitting apparatus, the apparatus includes a mounting substrate and a light-emitting unit.

The mounting substrate includes a connecting pattern, an electrical connecting portion, and an in-board interconnection region. The electrical connecting portion is located on a surface of the mounting substrate and is electrically connected to the connecting pattern through the in-board interconnection region.

The light-emitting unit includes a packaging shell and at least two laser chip groups with different light-emitting colors disposed in the packaging shell. Each laser chip group includes one laser chip or more laser chips connected in series. The light-emitting unit is fixed to the mounting substrate and is electrically connected to the connecting pattern.

The electrical connecting portion is configured in a plurality of groups and corresponds to the at least two laser chip groups, respectively. Each group of electrical connecting portions includes a positive electrode connecting portion and a negative electrode connecting portion. The positive electrode connecting portion is connected to a positive electrode of a laser chip group of a corresponding color, and the negative electrode connecting portion is connected to a negative electrode of the laser chip group of the corresponding color.

In a second aspect, embodiments of the present disclosure provide a laser projection device, and the laser projection device includes a light-emitting apparatus and a driving circuit.

The light-emitting apparatus is the light-emitting apparatus described in any of the above.

A number of driving circuits is same as a number of laser chip groups in the light-emitting apparatus.

The positive electrode connecting portion connected to a laser chip group is electrically connected to a positive electrode of a corresponding driving circuit, and the negative electrode connecting portion connected to the laser chip group is electrically connected to a negative electrode of the corresponding driving circuit.

### BRIEF DESCRIPTION OF THE DRAWINGS

In order to describe embodiments of the present disclosure or implementations in related art more clearly, the accompanying drawings to be used in some embodiments or in related art will be introduced briefly. However, the accompanying drawings to be described below are merely accompanying drawings of some embodiments of the present disclosure, and a person of ordinary skill in the art may obtain other accompanying drawings according to those accompanying drawings.
FIG. 1 shows a working principle of a laser device in related art;
FIG. 2 shows a schematic circuit diagram of a common anode wiring scheme in related art;
FIG. 3 shows a schematic circuit diagram of a common cathode wiring scheme in related art;
FIG. 4 is a schematic diagram showing a structure of a light-emitting apparatus provided in some embodiments of the present disclosure;
FIG. 5 is a circuit diagram of a light-emitting apparatus provided in some embodiments of the present disclosure;
FIG. 6 is a schematic diagram showing a structure of a packaging shell facing toward a side of a mounting substrate provided in some embodiments of the present disclosure;
FIG. 7 is a schematic diagram showing a structure of a mounting substrate provided in some embodiments of the present disclosure;
FIG. 8 shows a wiring diagram of the mounting substrate in the light-emitting apparatus shown in FIG. 7;
FIG. 9 is a schematic diagram showing a structure of another light-emitting apparatus provided in some embodiments of the present disclosure;
FIG. 10 is a schematic diagram showing a structure of another mounting substrate provided in some embodiments of the present disclosure;
FIG. 11 is a schematic diagram showing a structure of yet another mounting substrate provided in some embodiments of the present disclosure;
FIG. 12 is a schematic diagram showing a structure of yet another mounting substrate provided in some embodiments of the present disclosure;
FIG. 13 is a circuit diagram showing a structure of a packaging shell provided in some embodiments of the present disclosure;
FIG. 14 is a schematic diagram showing a structure of yet another light-emitting apparatus provided in some embodiments of the present disclosure;
FIG. 15 shows a simplified diagram of a wiring in a first shell provided in some embodiments of the present disclosure;
FIG. 16 is a top view of a wiring in a first shell provided in some embodiments of the present disclosure;
FIG. 17 shows a cross-sectional view of a wiring in a first shell provided in some embodiments of the present disclosure;
FIG. 18 shows a simplified diagram of a wiring in a second shell provided in some embodiments of the present disclosure;
FIG. 19 is a top view of a wiring in a second shell provided in some embodiments of the present disclosure;
FIG. 20 shows a cross-sectional view of a wiring in a second shell provided in some embodiments of the present disclosure;
FIG. 21 is a circuit diagram showing a structure of a thermistor provided in some embodiments of the present disclosure;
FIG. 22 is a schematic diagram showing a structure of yet another light-emitting apparatus provided in some embodiments of the present disclosure;
FIG. 23 is a schematic diagram showing a structure of yet another mounting substrate provided in some embodiments of the present disclosure;
FIG. 24 is a schematic diagram showing a structure of yet another light-emitting apparatus provided in some embodiments of the present disclosure;
FIG. 25 is a schematic diagram showing a structure of another packaging shell facing toward a side of a mounting substrate provided in some embodiments of the present disclosure;
FIG. 26 is a schematic diagram showing a structure of yet another light-emitting apparatus provided in some embodiments of the present disclosure;
FIG. 27 is a schematic diagram showing a structure of yet another mounting substrate provided in some embodiments of the present disclosure;
FIG. 28 shows a top view of a wiring in a packaging shell provided in some embodiments of the present disclosure;
FIG. 29 is a schematic diagram showing a structure of yet another light-emitting apparatus provided in some embodiments of the present disclosure;
FIG. 30 is a schematic diagram showing a structure of yet another packaging shell facing toward a side of a mounting substrate provided in some embodiments of the present disclosure;
FIG. 31 is a schematic diagram showing a structure of a laser projection device provided in some embodiments of the present disclosure;
FIG. 32 shows a schematic diagram of a projection imaging optical path of a laser projection device provided in some embodiments of the present disclosure;
FIG. 33 is a schematic diagram showing a structure of a circuit control principle of a laser projection device provided in some embodiments of the present disclosure; and
FIG. 34 is a schematic diagram showing a structure of a projection system provided in some embodiments of the present disclosure.

Reference signs in the attached figures represent:
1. Mounting substrate; 11. Electrical connecting portion/connecting pad; 111. Positive electrode connecting portion; 112. Negative electrode connecting portion;
12. In-board interconnection region; 13. Connecting pattern; 131. Conductive region; 132. Metal portion; 1311. Transfer pad;
2. Light-emitting unit;
20. Laser chip group; 201. First color chip group; 202. Second color chip group; 203. Third color chip group;
21. Laser chip; 211. First color chip; 212. Second color chip; 213. Third color chip;
22. Packaging shell; 221. First shell; 222. Second shell;
23. Tube wall wiring; 24. Conductive structure; 241. Bottom pads; 25. Metal film; 26. Stepped portion;
3. Thermistor; 4. Lens; 5. Reflective prism; 6. Heat sink substrate; 7. Anti-static device;
001. Laser source;
002. Optical modulation assembly;
0021. Homogenizing component; 0022. Reflective mirror; 0023. Lens; 0024. Light valve; 0025. Prism assembly;
003. Projection lens;
004. Housing;
005. Display control circuit;
006. Optical driving circuit;
007. Power supply circuit;
A. Laser projection device;
B. Projection screen.

### DETAILED DESCRIPTION

To make the above-mentioned objectives, characteristics and advantages of the present disclosure apparent and understandable, the present disclosure will be further described below in conjunction with the accompanying drawings and embodiments. However, the exemplary embodiments can be implemented in many forms and should not be construed as a limitation to the embodiments set forth herein. Rather, these embodiments are provided to make the present disclosure complete and comprehensive and to fully convey the concept of the exemplary embodiments to those skilled in the art. The same reference signs in the drawings represent the same or similar structures, and therefore repeated descriptions of them will be omitted. The terms used in the present disclosure to express position and orientation are illustrated with the accompanying drawings, but may be changed as needed, and all such changes are included within the scope of protection of the present disclosure. The accompanying drawings in the present disclosure are used for illustrate the relative positional relationship and do not represent actual proportion.

In order to make the purposes and embodiments of the present disclosure clear, the exemplary embodiments of the present disclosure will be described clearly and completely below with reference to the accompanying drawings. However, the described exemplary embodiments are merely some but not all embodiments of the present disclosure.

It should be noted that the brief descriptions of terms in the present disclosure are for the purpose of facilitating the understanding of the embodiments described below, and are not intended to limit the embodiments of the present disclosure. Unless otherwise specified, these terms should be understood in their ordinary and common meanings.

The terms "comprising" and "having", and any variations thereof, are intended to cover but not exclude inclusion. For example, a product or device that includes a series of components is not necessarily limited to all of the components that are clearly listed, but may include other components that are not clearly listed or that are inherent to such product or device.

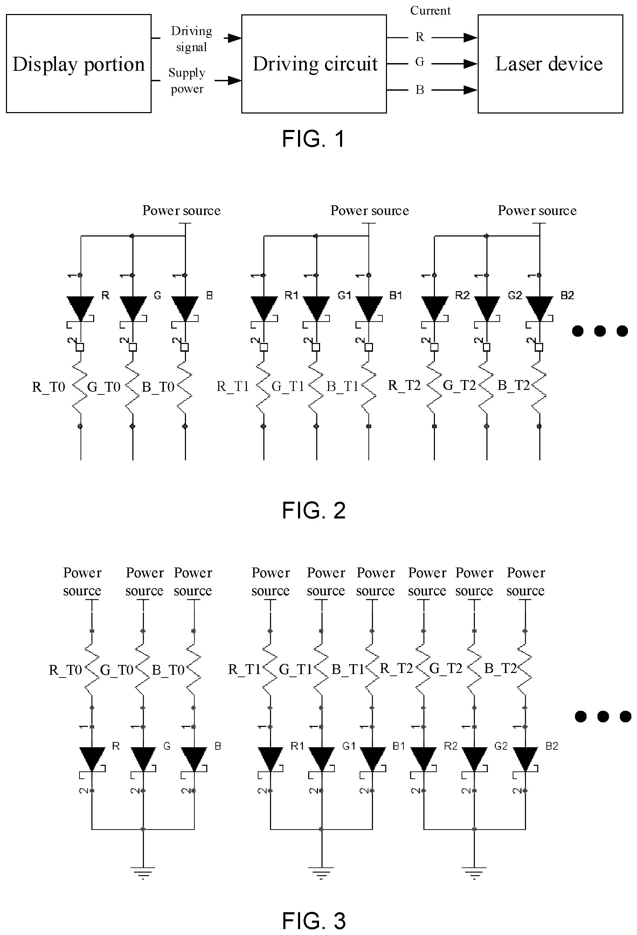

The working principle of the laser projection device involved in the related art is shown in FIG. 1. A display portion of the laser projection device supplies power to a driving circuit and provides driving signals. The driving circuit is used to transmit driving signals to the three-color laser device. When powered on, the three-color laser device emits laser beams based on the received driving signals.

FIG. 2 shows three laser devices with a common anode wiring, and FIG. 3 shows three laser devices with a common cathode wiring. The three RGB laser chips in FIGS. 2 and 3 form a three-color laser device. R_T, G_T, and B_T are the driving circuits of the three-color laser device. When a plurality of three-color laser devices need to work simultaneously to increase brightness, the number of driving circuits (R_T0, G_T0, B_T0, ..., R_Tn, G_Tn, B_Tn) increases with the number of laser devices. The increase in driving circuits leads to a decrease in the working efficiency of the driving circuits and an increase in cost.

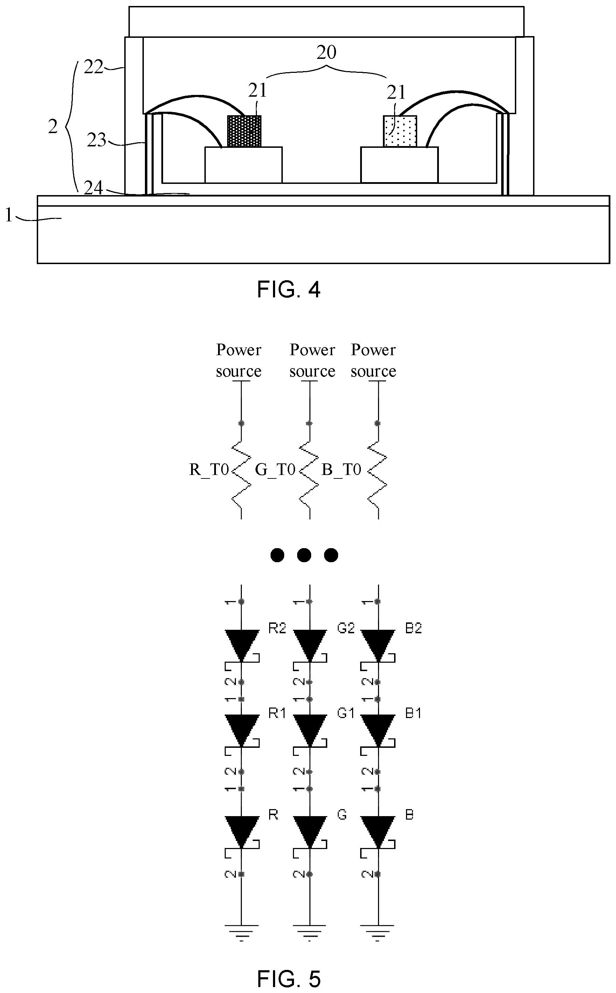

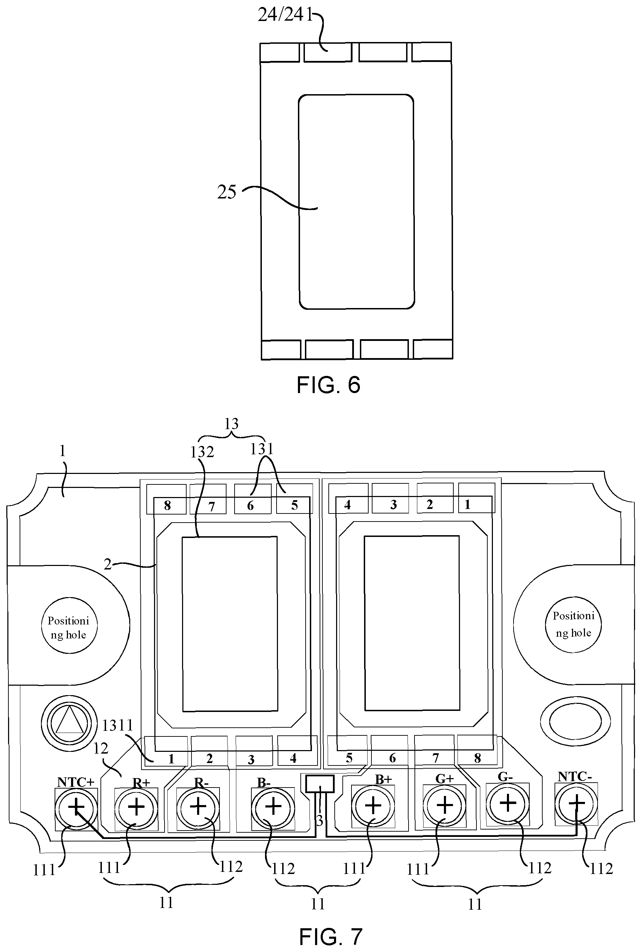

To solve the above-mentioned technical problems, some embodiments of the present disclosure provide a light-emitting apparatus and a laser projection device. As shown in FIGS. 4 to 7, the light-emitting apparatus includes a mounting substrate 1 and a light-emitting unit 2. Referring to FIG. 7, the mounting substrate 1 includes a connecting pattern 13, an electrical connecting portion 11, and an in-board interconnection region 12. The electrical connecting portion 11 is located on a surface of the mounting substrate 1, and is electrically connected to the connecting pattern 13 through the in-board interconnection region 12. Referring to FIG. 4, the light-emitting unit 2 includes a packaging shell 22 and at least two laser chip groups 20 with different light-emitting colors disposed in the packaging shell 22. Each laser chip group 20 includes one laser chip 21 or more laser chips 21 connected in series. The light-emitting unit 2 is fixed to the mounting substrate 1 and is electrically connected to the connecting pattern 13. The electrical connecting portion 11 is configured in a plurality of groups and the plurality of groups of electrical connecting portions 11 correspond to the at least two laser chip groups 20. Each group of electrical connecting portions 11 includes a positive electrode connecting portion 111 and a negative electrode connecting portion 112. The positive electrode connecting portion 111 is connected to a positive electrode of a laser chip group 20 of a corresponding color, and a negative electrode connecting portion 112 is connected to a negative electrode of the laser chip group 20 of the corresponding color.

The light-emitting apparatus provided in some embodiments of the present disclosure, on the one hand, by electrically connecting a light-emitting laser chip group 20 of each light-emitting color in the light-emitting unit 2 to a corresponding group of positive electrode connecting portion 111 and negative electrode connecting portion 112 on the mounting substrate 1. During application, a number of driving circuits is provided to be consistent with a number of laser chip groups 20. For example, the positive electrode connecting portion 111 connected to the laser chip group 20 is electrically connected to a positive electrode of a corresponding driving circuit, and the negative electrode connecting portion 112 connected to the laser chip group 20 is electrically connected to a negative electrode of the corresponding driving circuit. As a result, the driving circuit may provide power supply and driving for the laser chips 21 with different light-emitting colors separately. If a new light-emitting apparatus (i.e., a laser device) is added, it is necessary to connect the new light-emitting apparatus in series with an original light-emitting apparatus, so that the laser chip groups 20 with a same light-emitting color in the plurality of light-emitting apparatuses are connected in series and share a single driving circuit. There is no need to add new driving circuits as the number of light-emitting apparatuses increases, which solves the problem that the number of laser devices used is limited by the driving circuit. The number of driving circuits will not increase while the number of laser devices increases, which not only effectively improves the working efficiency of the driving circuit, but also reduces costs. On the other hand, by making the mounting substrate 1 include the connecting pattern 13, the electrical connecting portion 11 and the in-board interconnection region 12, the light-emitting unit 2 is electrically connected to the connecting pattern 13, and the connecting pattern 13 is also electrically connected to the electrical connecting portion 11 through the in-board interconnection region 12, thereby achieving electrical connection between the electrical connecting portion 11 and the laser chip group 20 in the light-emitting unit 2. In some embodiments of the present disclosure, the electrical connecting portion 11 is located on the surface of the mounting substrate 1. Compared to the electrical connecting portion 11 disposed on a wall of the packaging shell 22 (e.g., extending along a direction parallel to the mounting substrate 1), which is conducive to reducing a volume of the light-emitting apparatus and miniaturization design of the light-emitting apparatus.

FIG. 5 illustrates the three-color separately driving principle of a three-color laser device. As shown in FIG. 5, the light-emitting unit 2 may include three laser chip groups 20 with different light-emitting colors, that is, a laser chip group 20 with a red light-emitting color, a laser chip group 20 with a green light-emitting color, and a laser chip group 20 with a blue light-emitting color. The laser chip group with the red light-emitting color includes a plurality of red laser chips 21 (referred to as R) connected in series, and a red light driving circuit (referred to as R_T0) is correspondingly connected to the positive electrode connecting portion 111 and the negative electrode connecting portion 112 connected to the laser chip group. The laser chip group with the green light-emitting color includes a plurality of green laser chips 21 (referred to as G) connected in series, and a green light driving circuit (referred to as G_T0) is correspondingly connected to the positive electrode connecting portion 111 and the negative electrode connecting portion 112 connected to the laser chip group. The laser chip group with the blue light-emitting color includes a plurality of blue laser chips 21 (referred to as B) connected in series, and a blue light driving circuit (referred to as G_T0) is correspondingly connected to the positive electrode connecting portion 111 and the negative electrode connecting portion 112 connected to the laser chip group. It can be seen that the laser chip group 20 where the red light laser chip 21 is located, the laser chip group 20 where the green light laser chip 21 is located, and the laser chip group 20 where the blue light laser chip 21 is located are powered and driven separately.

For each laser chip group 20 with a single light-emitting color, a number of laser chips 21 included therein may be adjusted according to the light-emitting brightness requirement. As the brightness requirement increases, the number of laser chips 21 included therein also increases accordingly. In a case where each laser chip group 20 with the light light-emitting color includes a plurality of laser chips 21, the plurality of laser chips 21 may be connected in series.

In some examples, there are a plurality of light-emitting apparatuses, and a plurality of groups of electrical connecting portions 11 corresponding to the laser chip group 20 with the same light-emitting color are connected in series in the plurality of light-emitting apparatuses.

For example, for a certain laser projection device, if a three-color light-emitting apparatus B is added to a three-color light-emitting apparatus A. A group of electrical connecting portions 11 of the laser chip group 20 corresponding to the red light-emitting color in the three-color light-emitting device A is connected in series with a group of electrical connecting portions 11 of the laser chip group 20 corresponding to the red light-emitting color in the three-color light emission device B, and they may share a single red light driving circuit. A group of electrical connecting portions 11 of the laser chip group 20 corresponding to the green light-emitting color in the three-color light-emitting device A is connected in series with a group of electrical connecting portions 11 of the laser chip group 20 corresponding to the green light-emitting color in the three-color light emission device B, and they may share a single green light driving circuit. A group of electrical connecting portions 11 of the laser chip group 20 corresponding to the blue light-emitting color in the three-color light-emitting device A is connected in series with a group of electrical connecting portions 11 of the laser chip group 20 corresponding to the blue light-emitting color in the three-color light emission device B, and they may share a single blue light driving circuit.

It can be seen that as the number of light-emitting apparatuses in laser projection device increases, the number of driving circuits does not increase. As a result, it is conducive to ensuring the working efficiency and low cost of the driving circuits. Furthermore, the increase in the number of light-emitting apparatuses also benefits the increase in light brightness and optical path, thereby improving the light-emitting effect.

A conductive structure 24 is provided on a side of the packaging shell 22 facing toward the mounting substrate 1. A conductive region 22 is also provided on the connecting pattern 13. The light-emitting unit 2 is fixed on the connecting pattern 13 and electrically connected to the conductive region 22. The laser chip group 20 is electrically connected to a tube wall wiring 23 of the packaging shell 22. The tube wall wiring 23 is also electrically connected to the conductive structure 24.

As described above, the mounting substrate 1 includes the connecting pattern 13, the electrical connecting portion 11, and the in-board interconnection region 12. The electrical connecting portion 11 is electrically connected to the connecting pattern 13 through the in-board interconnection region 12. The light-emitting unit 2 includes the packaging shell 22 and the laser chip groups 20 disposed in the packaging shell 22. The electrical connecting portion 11 and the light-emitting unit 2 are located on a same surface of the mounting substrate 1.

In order to achieve electrical connection between the laser chip group 20 and the electrical connecting portion 11, as shown in FIG. 6, the conductive structure 24 is provided on the side of the packaging shell 22 facing toward the mounting substrate 1. As shown in the drawings, the connecting pattern 13 is also provided with the conductive region 131. The light-emitting unit 2 is fixed on the connecting pattern 13 and is electrically connected to the conductive region 131. The laser chip group 20 is electrically connected to the tube wall wiring 23 of the packaging shell 22, and the tube wall wiring 23 is also electrically connected to the conductive structure 24.

With such configuration, the light-emitting unit 2 is fixed on the mounting substrate 1. For example, the light-emitting unit 2 is fixed on the connecting pattern 13, and each laser chip group 20 of each light-emitting color is sequentially connected to a corresponding group of electrical connecting portions 11 (positive electrode connecting portion 111 and negative electrode connecting portion 112) through the tube wall wiring 23, the conductive structure 24, the conductive region 131 and the in-board interconnection region 12, thereby achieving power supply for laser chip groups 20 of different colors separately.

The light-emitting apparatus and laser projection device provided in the embodiments of the present disclosure will be described exemplarily below with reference to the accompanying drawings.

In some embodiments, as shown in FIG. 4, the light-emitting apparatus includes the mounting substrate 1 and the light-emitting unit 2, the light-emitting unit 2 is located on a side of the mounting substrate 1. As shown in FIGS. 7 to 8, a side of the mounting substrate 1 facing toward the light-emitting unit 2 is provided with the connecting pattern 13, the electrical connecting portion 11, and the in-board interconnection region 12. For example, the in-board interconnection region 12 is a metal film layer, and the electrical connecting portion 11 is electrically connected to the conductive region 131 of the connecting pattern 13 through the in-board interconnection region 12. As shown in FIG. 7, the connecting pattern 13 includes a metal portion 132 and the conductive region 131. The metal portion 132 is a portion that fixes the light-emitting unit 2. For example, the metal portion 132 is in a shape of a rectangle when viewed from above in FIG. 7. The metal portion 132 may be made of copper, for example, to serve as a heat sink. The conductive region 131 is electrically connected to the light-emitting unit 2. A region marked by a thick black frame in FIG. 7 is the fixed position of the light-emitting unit 2 on the mounting substrate 1.

As shown in FIG. 4, the light-emitting unit 2 includes the packaging shell 22 and a laser chip 21, and the laser chip 21 is located in the packaging shell 22.

For example, the packaging shell 22 includes a shell bottom wall, a shell sidewall, and a sealing glass. The shell bottom wall is parallel to a plane where the mounting substrate 1 is located, the shell sidewall is perpendicular to the plane where the mounting substrate 1 is located, and the sealing glass is located on a side of the shell sidewall away from the shell bottom wall. The shell bottom wall, the shell sidewall, and the sealing glass form a sealed space, and the laser chip 21 is located in the sealed space.

The tube wall wiring 23 may be disposed in at least one of the shell bottom wall and the shell side wall of the shell, and at least one of the shell bottom wall and the shell side wall of the shell may be made of a ceramic material.

As shown in FIG. 6, a side of the packaging shell 22 facing the mounting substrate 1 (i.e., a lower surface of the shell bottom wall of the shell) is provided with the conductive structure 24 and a metal film 25. The conductive structure 24 is formed opposite to the conductive region 131 of the mounting substrate 1, and the metal film 25 is formed opposite to the metal portion 132 of the mounting substrate 1. The metal film 25 and the metal portion 132 serve as heat sinks. For example, both of the metal film 25 and the metal portion 132 are made of copper.

The laser chip group 20 is electrically connected to the conductive structure 24 through the tube wall wiring 23 of the packaging shell 22. The conductive structure 24 is electrically connected to the conductive region 131 of the mounting substrate 1. The conductive region 131 is electrically connected to the electrical connecting portion 11 through the in-board interconnection region 12, thereby achieving the electrical connection between the laser chip 21 and the electrical connecting portion 11. The electrical connecting portion 11 is used to connect to the driving circuit. For example, the electrical connecting portion 11 may be connected to the driving circuit through a connector, a flexible substrate, an epoxy glass substrate, a leaf spring terminal and the like.

For example, the material of the packaging shell 22 may be ceramic, and the tube wall wiring 23 may be disposed in at least one of the shell sidewall and the shell bottom wall.

The laser chip group 20 includes at least two laser chips 21 of different colors. A laser chip 21 of each color is connected to a group of electrical connecting portions 11, and is electrically connected to the corresponding group of electrical connecting portions 11 through the tube wall wiring 23, the conductive structure 24, the conductive region 131 and the in-board interconnection region 12, thereby achieving power supply for the laser chip 21 of each color separately.

For example, as shown in FIG. 4, the laser chip group 20 includes a laser chip 21 with a first light-emitting color and a laser chip 22 with a second light-emitting color. For example, the laser chip 21 with the first light-emitting color emits blue laser beams, and the laser chip 22 with the second light-emitting color emits red or green laser beams. The laser chip 22 with the first light-emitting color is electrically connected to two corresponding electrical connecting portions 11, and the laser chip 22 with the second light-emitting color is electrically connected to two corresponding electrical connecting portions 11. Therefore, at least four electrical connecting portions 11 need to be provided on the mounting substrate 1.

It should be noted that FIG. 4 shows, by way of example, two laser chip groups 20 with different light-emitting colors in the light-emitting apparatus, however, it does not constitute a limitation on the light-emitting apparatus provided in the embodiments of the present disclosure. In other embodiments, the laser chip group 20 may also include three laser chips 21 with light-emitting colors. The three laser chips 21 emit laser beams of different colors, respectively. The three laser chips 21 are electrically connected to the corresponding electrical connecting portions 11 through the tube wall wiring 23 and the conductive structure 24 of the packaging shell 22, and are powered separately, the present disclosure is not limited thereto.

Referring to FIG. 5, the light-emitting apparatus includes three laser chip groups 20: red, green, and blue (RGB). Each laser chip group 20 of each color is connected to a corresponding driving circuit. No matter how the number of laser chip groups 20 of each color increases, the number of driving circuits will not change. As a result, it is possible to solve the problem that the number of laser chips used is limited by the driving circuit, which may effectively improve the working efficiency of the driving circuit and reduce costs.

In some embodiments, in order to achieve power supply separately and meet the requirements of miniaturization design, the mounting substrate 1 is a copper substrate, and the copper substrate is a single-sided panel (i.e., a single-sided board), so that there is enough space on a back of the copper substrate to dissipate heat, which is conducive to the heat dissipation of the light-emitting apparatus.

The dimensions of the mounting substrate 1 are not limited in the present disclosure and may be flexibly provided according to requirements. For example, the mounting substrate 1 is a 15.8mm×26mm copper substrate with a thickness of 1.6mm.

In some embodiments, a thickness of a circuit board portion in the mounting substrate 1 is 2 oz (ounce), approximately 70 micrometers.

In some embodiments, as shown in FIGS. 6 to 8, in a direction perpendicular to the plane where the mounting substrate 1 is located, the electrical connecting portion 11 at least partially overlaps with the in-board interconnection region 12, the connecting pattern 13 at least partially overlaps with the in-board interconnection region 12, and the conductive structure 24 at least partially overlaps with the connecting pattern 13.

The electrical connecting portion 11, the in-board interconnection region 12, and the connecting pattern 13 each are located on the surface of the mounting substrate 1 facing toward the light-emitting unit 2.

In some examples, in the direction perpendicular to the plane where the mounting substrate 1 is located, the electrical connecting portion 11 at least partially overlaps with the in-board interconnection region 12, the connecting pattern 13 at least partially overlaps with the in-board interconnection region 12, and the conductive structure 24 at least partially overlaps with the connecting pattern 13.

In the direction perpendicular to the plane where the mounting substrate 1 is located, there is an overlapping region between the electrical connecting portion 11 and the in-board interconnection region 12. The overlapping region is a connecting region between the electrical connecting portion 11 and the in-board interconnection region 12. The larger the connecting area between the electrical connecting portion 11 and the in-board interconnection region 12, the more it is conducive to improving the stability of the electrical connection and the current.

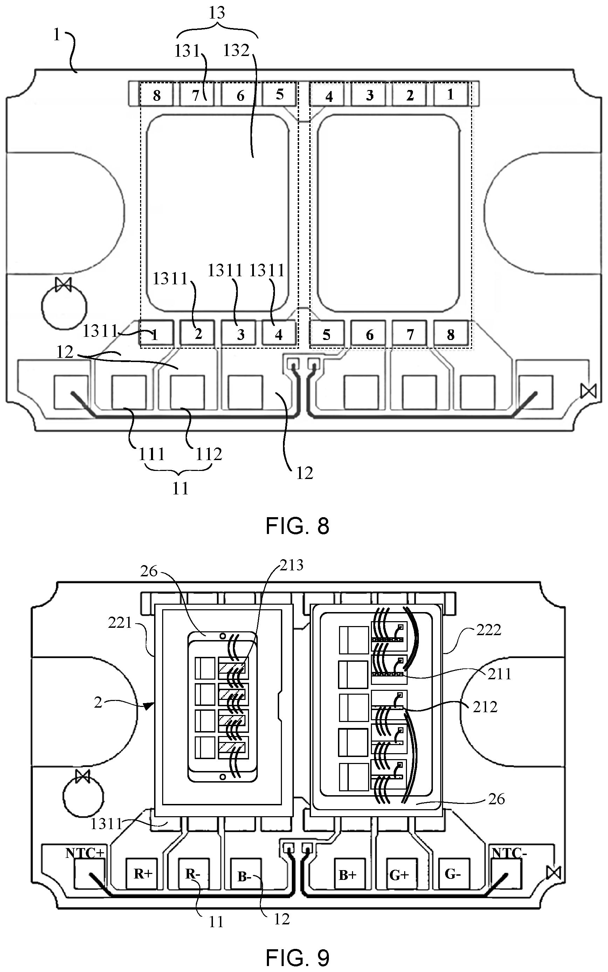

The electrical connecting portion 11 at least partially overlaps with the in-board interconnection region 12, including: the electrical connecting portion 11 is located within the in-board interconnection region 12 (as shown in FIG. 7 or FIG. 8), or the electrical connecting portion 11 partially overlapping with the in-board interconnection region 12, and there are also regions where they do not overlap with each other.

In the direction perpendicular to the plane where the mounting substrate 1 is located, there is an overlapping region between the connecting pattern 13 (or the conductive region 131) and the in-board interconnection region 12. The overlapping region is a connecting region between the connecting pattern 13 (or the conductive region 131) and the in-board interconnection region 12. The larger the connecting area between the connecting pattern 13 and the in-board interconnection region 12, the more it is conducive to improving the stability of the electrical connection and the current. The connecting pattern 13 at least partially overlaps with the in-board interconnection region 12, including: the conductive region 131 of the connecting pattern 13 is located within the in-board interconnection region 12 (as shown in FIG. 7 or FIG. 8), or the conductive region 131 of the connecting pattern 13 partially overlaps with the in-board interconnection region 12, and there are also regions where they do not overlap with each other. With such configuration, the electrical connecting portion 11 is electrically connected to the connecting pattern 13 through the in-board interconnection region 12.

In the direction perpendicular to the plane where the mounting substrate 1 is located, the conductive structure 24 at least partially overlaps with the connecting pattern 13. That is, there is an overlapping region between the conductive structure 24 and the connecting pattern 13, thereby achieving the electrical connection between the conductive structure 24 and the connecting pattern 13.

As shown in FIG. 7 or FIG. 8, on the plane where the mounting substrate 1 is located, a plurality of groups of connecting portions 11 are located on a same side edge of the mounting substrate 1, that is, the plurality of groups of connecting portions 11 are located on a side of the packaging shell 22. For example, the plurality of groups of connecting portions 11 are arranged side by side, which not only ensures the miniaturization of the entire light-emitting apparatus, but also makes an appearance of the light-emitting apparatus beautiful, and may also enhance an operability of manual soldering.

In other embodiments, the electrical connecting portion 11 may also be located on opposite sides of the packaging shell 22. In this way, it can achieve power supply for laser chip of each color separately, however, it may not conducive to miniaturization.

As shown in FIG. 7, the plurality of groups of electrical connecting portions 11 are arranged side by side. FIG. 7 illustrates that the plurality of groups of electrical connecting portions 11 are arranged side by side and spaced apart along a width direction of the side edge of the mounting substrate 1. In this way, it is conducive to making a space occupied by the plurality of groups of electrical connecting portions 11 on the mounting substrate 1 concentrated, and is conducive to the miniaturization of the light-emitting apparatus.

Furthermore, at least some of the electrical connecting portions in the positive electrode connecting portions 111 and negative electrode connecting portions 112 included in the plurality of groups of electrical connecting portions 11 are arranged adjacent to each other with a same polarity. For example, FIG. 7 illustrates that R- in the negative electrode connecting portion 112 is arranged adjacent to B- in the negative electrode connecting portion 112, and B+ in the negative electrode connecting portion 112 is arranged adjacent to G+ in the negative electrode connecting portion 112. In this way, it is conducive to preventing the problem of short circuit between positive electrode and negative electrode caused by welding errors.

As shown in FIG. 6, the conductive structure 24 includes a plurality of bottom pads 241. As shown in FIG. 7, the connecting pattern 13 includes a plurality of transfer pads 1311. The plurality of transfer pads 1311 are electrically connected to the plurality of bottom pads 241, respectively. The plurality of bottom pads 241 are also electrically connected to the tube wall wiring 23. The plurality of transfer pads 1311 are also electrically connected to the electrical connecting portions 11 through the in-board interconnection regions 12. The plurality of transfer pads 1311 are arranged side by side and are located at least on a side of the connecting pattern 13 proximate to the plurality of electrical connecting portions 11, and a side-by-side arrangement direction of the plurality of groups of transfer pads 1311 is same as a side-by-side arrangement direction of the plurality of groups of electrical connecting portions 11.

The number of the plurality of transfer pads 1311 may be same as the number of the plurality of bottom pads 241, and positions of the plurality of transfer pads 1311 correspond to positions of the plurality of bottom pads 241 respectively, so that the two may be connected and electrically connected in an opposing manner. By arranging the plurality of transfer pads 1311 side by side and at least on the side of the connecting pattern 13 proximate to the plurality of groups of electrical connecting portions 11, and the side-by-side arrangement direction of the plurality of transfer pads 1311 is the same as the side-by-side arrangement direction of the plurality of groups of electrical connecting portions 11. In this way, it is conducive to making a wiring structure on the mounting substrate 1 compact and to achieving the miniaturization of the mounting substrate 1.

In some examples, the number of the plurality of transfer pads 1311 is greater than a total number of the positive electrode connecting portion 111 and the negative electrode connecting portion 112 included in the plurality of groups of electrical connecting portions 11, such that some of the positive electrode connecting portions 111 or the negative electrode connecting portions 112 are connected to the transfer pads 1311 in a one-to-many manner. It should be noted that for a scheme that uses the plurality of transfer pads 1311 connected to one electrical connecting portion 11, the plurality of transfer pads 1311 must be connected through a same in-board interconnection region 12 to ensure that a current electrical connecting portion 11 is connected to a target laser chip group 20.

Considering FIG. 7 as an example, B- in the negative electrode connecting portion 112 is connected through a transfer pad 1311 labeled 3, a transfer pad 1311 labeled 4 and a transfer pad 1311 labeled 5 above it, that is, B- and the transfer pads 1311 are connected in a one-to-three manner.

The above arrangement can, on the one hand, increase a width of wiring on the mounting substrate 1, thereby increasing a current that can pass through. The higher the current, the stronger the luminous intensity of the light-emitting apparatus. On the other hand, it has greater adaptability to mounting other components on the mounting substrate 1. For example, FIG. 7 illustrates that the mounting substrate 1 is further provided with a thermistor 3. The thermistor 3 blocks a direct connection between B- in the negative electrode connecting portion 112 and a transfer pad 1311 corresponding to a blue laser chip group 20. The aforementioned one-to-three connection between B- and the transfer pads 1311 indirectly achieves electrical conduction between B- in the negative electrode connecting portion 112 and the transfer pads 1311 corresponding to the blue laser chip group 20.

Based on any one of the plurality of light-emitting apparatuses mentioned above, the electrical connecting portions 11 (positive electrode connecting portion 111 and negative electrode connecting portion 112) involved may be in a form of a solder pad, that is, the electrical connecting portions 11 are connecting pads 11.

The electrical connecting portion 11 adopts the form of the solder pad, which is conducive to simplifying a fabrication process of the electrical connecting portion 11 on the mounting substrate 1 and facilitating the connection between the light-emitting apparatus and the driving circuit by means of soldering. Of course, it is possible that the electrical connecting portion 11 may also be designed as other electrical connector manners, such as plug-in type electrical connectors, crimp-type electrical connectors, and the like.

In some embodiments, in the plane where the mounting substrate 1 is located, a width of a single side of the electrical connecting portion 11 (connecting pad 11) is any value range from 1.3mm to 1.7mm, inclusive; and along the arrangement direction of the plurality of electrical connecting portions 11, a distance between adjacent electrical connecting portions 11 is any value range from 0.8mm to 1.2mm, inclusive. Within the aforementioned size range, on the one hand, short circuits caused by solder overflow during soldering between adjacent connecting pads 11 may be avoided; on the other hand, it is also conducive to achieving the compact structure and miniaturization of the mounting substrate 1.

In some embodiments, in the plane where the mounting substrate 1 is located, a long side width of the transfer pad 1311 is any value range from 1.1mm to 1.5mm, inclusive, and a short side width of the transfer pad 1311 is any value range from 0.4mm to 0.8mm, inclusive; along the arrangement direction of the plurality of transfer pads 1311, the distance between adjacent transfer pads 1311 is any value range from 0.1mm to 0.5mm, inclusive.

The embodiments of the present disclosure do not limit the size (including length and width) of the packaging shell 22, and the size of the packaging shell 22 may be provided according to the requirements of the light-emitting apparatus. For example, the size of the packaging shell 22 is 10.6mm × 6.4mm.

In some examples, as shown in FIG. 7, the light-emitting apparatus involved in the embodiments of the present disclosure further includes: the thermistor 3, and a single group of electrical connecting portions 11 corresponding to the thermistor 3 is provided on the mounting substrate 1. Two ends of the thermistor 3 are electrically connected to the positive electrode connecting portion 111 and the negative electrode connecting portion 112 of the corresponding group of electrical connecting portions 11, respectively.

The thermistor 3 is connected to the corresponding group of electrical connecting portions 11 through wiring. The thermistor 3 is used to detect a heating status of the laser chip groups 20.

For example, the thermistor 3 includes a negative temperature coefficient thermistor (NTC), or other types of thermistors known to those skilled in the art, which are not limited herein. For example, FIG. 7 illustrates the thermistor 3 as an NTC type.

For example, as shown in FIG. 7, the thermistor 3 is located between the plurality of groups of electrical connecting portions 11 and the at least two laser chip groups 20, and the plurality of groups of electrical connecting portions 11 are symmetrically arranged on both sides of the thermistor 3.

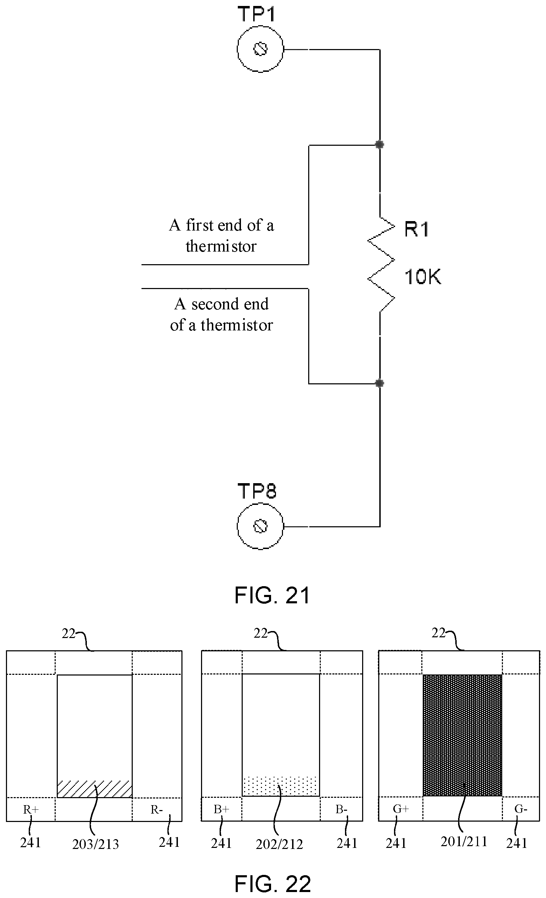

In other words, the thermistor 3 is located on a side of the connecting pattern 13 proximate to the plurality of groups of electrical connecting portions 11. FIG. 7 also illustrates that eight electrical connecting portions 11 are symmetrically arranged on both sides of the thermistor 3. The group of electrical connecting portions 11 corresponding to the thermistor 3 (i.e., NTC+ and NTC-) is located on an outermost side. A corresponding circuit diagram is shown in FIG. 21. The thermistor 3 is electrically connected to a thermistor positive polarity pad (NTC+) and a thermistor negative polarity pad (NTC-) through a corresponding in-board interconnection region 12. TP1 represents the thermistor positive polarity pad (NTC+) and TP8 represents the thermistor negative polarity pad (NTC-).

In conjunction with any one of the light-emitting apparatuses mentioned above, the following describes some exemplary examples of the light-emitting apparatus to clearly show the wiring method of the light-emitting apparatuses involved in the embodiments of the present disclosure.

In some embodiments, as shown in FIGS. 7 to 9, the laser chip group 20 includes a first color chip group 201, a second color chip group 202, and a third color chip group 203, with different light-emitting colors. The first color chip group 201 includes a plurality of first color chips 211 connected in series, the second color chip group 202 includes a plurality of second color chips 212 connected in series, and the third color chip group 203 includes a plurality of third color chips 213 connected in series.

Each color of laser chips 21 located in a same packaging shell 22 is connected in series and is connected to a group of two connecting pads 11 (a group of connecting pads 11 including a positive polarity pad and a negative polarity pad). A number of connecting pads 11 is twice a number of color types of laser chip groups 20, and connecting pads 11 of a same polarity are arranged adjacent to each other.

In the present embodiment, three groups of laser chip groups 20 include three types of laser chips: a first color chip 211, a second color chip 212, and a third color chip 213. Each type of laser chips 21 emits laser beams of a different color, and the light-emitting colors of the first color chip 211, the second color chip 212, and the third color chip 213 are different from each other. For example, a light emission wavelength of the third color chip group 203 is greater than that of the first color chip group 201 and the second color chip group 202. To illustrate further, here are some examples.

The first color chip 211 emits blue laser beams, the second color chip 212 emits green laser beams, and the third color chip 213 emits red laser beams. Alternatively, the first color chip 211 emits the green laser beams, the second color chip 212 emits the blue laser beams, and the third color chip 213 emits the red laser beams.

The light-emitting apparatus includes at least one packaging shell 22, and at least one group of laser chip group 3 may be disposed in a single packaging shell 22. Within the same packaging shell 22, all laser chips 21 with the same light-emitting color are connected in series and connected to a corresponding group of connecting pads 11.

For example, as shown in FIG. 9, the light-emitting apparatus includes a first shell 221 and a second shell 222 arranged side by side. The third color chip group 203 is disposed in the first shell 221, and the first color chip group 201 and the second color chip group 202 are disposed in the second shell 222. That is, the light-emitting apparatus includes two packaging shells 22. Four third color chips 213 are disposed in the first shell 221 on a left side. The four third color chips 213 are connected in series. Two ends of the series circuit line are electrically connected to stepped portions 26 on both sides respectively. A metal film is provided on an upper surface of the stepped portion 26. The metal film is electrically connected to the conductive structure 24 through the side wall wiring 23. The conductive structure 24 is electrically connected to the conductive region 131 of the connecting pattern 13. The connecting pattern 13 is electrically connected to the corresponding two connecting pads 11 through the in-board interconnection region 12, thereby achieving the electrical connection between the third color chip 213 and the corresponding group of connecting pads 11.

Two first color chips 211 and three second color chips 212 are disposed in the second shell 222 on a right side. The two first color chips 211 are connected in series, and two ends of the series circuit line are electrically connected to the stepped portion 26. The metal film on the upper surface of the stepped portion 26 is electrically connected to the conductive structure 24 through the side wall wiring 23. The conductive structure 24 is electrically connected to the conductive region 131 of the connecting pattern 13. The connecting pattern 13 is electrically connected to the corresponding two connecting pads 11 through the in-board interconnection region 12, thereby achieving the electrical connection between the first color chips 211 and the corresponding group of connecting pads 11.

Three second color chips 212 are connected in series. Two ends of the series circuit line are electrically connected to the stepped portion 26. The metal film on the upper surface of the stepped portion 26 is electrically connected to the conductive structure 24 through the side wall wiring 23. The conductive structure 24 is electrically connected to the conductive region 131 of the connecting pattern 13. The connecting pattern 13 is electrically connected to the two corresponding connecting pads 11 through the in-board interconnection region 12, thereby achieving the electrical connection between the first color chips 211 and the corresponding group of connecting pads 11.

It should be noted that FIG. 9 shows, by way of example, that the light-emitting apparatus includes two packaging shells 22, however, the present disclosure is not limited thereto. In other embodiments, the light-emitting apparatus may also include a single packaging shell 22, in which the first color chip 211, the second color chip 212, and the third color chip 213 are located in the single packaging shell 22. Alternatively, the light-emitting apparatus may include three packaging shells 22, in which the first color chip 211, the second color chip 212, and the third color chip 213 are correspond to the packaging shell 22, and the laser chip group 20 with the same light-emitting color is located in the same packaging shell 22, the present disclosure is not limited thereto.

For example, as shown in FIG. 7, the mounting substrate 1 includes four groups of connecting pads 11, the four groups of connecting pads are: a thermistor positive polarity pad (NTC+), a red positive polarity pad (R+) and a red negative polarity pad (R-), a blue positive polarity pad (B+) and a blue negative polarity pad (B-), a green positive polarity pad (G+) and a green negative polarity pad (G-), and a thermistor negative polarity pad (NTC-).

To prevent short circuits caused by soldering errors, positions of the connecting pads 11 are arranged according to the principle of adjacent pads of the same polarity. The arrangement of the eight connecting pads 11 from left to right is as follows: the thermistor positive polarity pad (NTC+), the red positive polarity pad (R+), the red negative polarity pad (R-), the blue negative polarity pad (B-), the blue positive polarity pad (B+), the green positive polarity pad (G+), the green negative polarity pad (G-), and the thermistor negative polarity pad (NTC-). That is, the thermistor positive polarity pad (NTC+) is adjacent to the red positive polarity pad (R+), the red negative polarity pad (R-) is adjacent to the blue negative polarity pad (B-), the blue positive polarity pad (B+) is adjacent to the green positive polarity pad (G+), and the green negative polarity pad (G-) is adjacent to the thermistor negative polarity pad (NTC-).

The present disclosure does not limit the type of the connecting pads 11. The type of the connecting pads 11 may be provided as a cross pad (as shown in FIG. 7). Alternatively, the type of the connecting pads 11 may also be provided as any type of pads known to those skilled in the art.

In some embodiments, as shown in FIG. 6, the conductive structure 24 includes a bottom pad 241, the bottom pad 241 is located on a side of the packaging shell 22 facing toward the mounting substrate 1, and the bottom pad 241 is connected to the tube wall wiring 23 in the packaging shell 22. As shown in FIG. 7 or FIG. 8, in the direction perpendicular to the plane where the mounting substrate 1 is located, the conductive region 131 of the connecting pattern 13 includes a transfer pad 1311, the transfer pad 1311 overlaps at least partially with the in-board interconnection region 12. The transfer pads 1311 are electrically connected to the bottom pads 241, respectively.

The transfer pad 1311 is electrically connected to the connecting pad 11 through the in-board interconnection region 12. The transfer pads 1311 are electrically connected to the bottom pads 241, respectively. The bottom pad 241 is electrically connected to the corresponding laser chip 21 through the tube wall wiring 23 in the packaging shell 22. The laser chips 21 with the same light-emitting color in the same packaging shell 22 are connected in series, thereby achieving the power supply of each color of laser chip separately. As the number of laser chips 21 increases, the number of drivering circuits will not increase, which is conducive to reducing costs.

In some embodiments, as shown in FIGS. 8 and 9, the first shell 221 and the second shell 222 each are provided with at least four bottom pads 241 arranged side by side on a side proximate to the connecting pads 11, and a plurality of transfer pads 1311 are provided on the mounting substrate 1 corresponding to the bottom pads 241. Two of the bottom pads 241 of the second shell 222 are connected to a group of connecting pads 11, and another two bottom pads 241 are connected to another group of connecting pads 11. Two of the bottom pads 241 of the first shell 221 that are away from the second shell 222 are connected to yet another group of connecting pads 11, and at least one of another two adjacent bottom pads 241 that is close to the second shell 222 is electrically connected to the bottom pad 241 of the second shell 222 that is close to the first shell 221.

In the present embodiment, the first shell 221 and the second shell 222 each are provided with the metal film 25 and the bottom pad 241 on the side facing toward the mounting substrate 1. The metal film 25 corresponds to and is fixedly connected to a fixing portion 132 of the connecting pattern 13. The bottom pad 241 corresponds to and is electrically connected to the transfer pad 1311. The connection path includes: the bottom pad 241 - the transfer pad 1311 - the in-board interconnection region 12 - the connecting pad 11. As a result, it is possible to achieve the fixation and electrical connection between the light-emitting unit 2 and the mounting substrate 1 (as shown in FIG. 9).

Referring to FIG. 7 or FIG. 8, a manner in which the first shell 221 and the second shell 222 are fixed to and electrically connected to the mounting substrate 1 is as follows: the fixing portion 132 of the connecting pattern 13 on a right side is fixedly connected to the metal film 25 of the second shell 222 facing toward a side of the mounting substrate. Transfer pads 1311 arranged side-by-side are provided on at least a side of the connecting pattern 13 proximate to the connecting pads 11. Two transfer pads 1311 are connected to a group of connecting pads 11 through the in-board interconnection region 12, and another two transfer pads 1311 are connected to another group of connecting pads 11 through the in-board interconnection region 12. The fixing portion 132 of the connecting pattern 13 on a left side is fixedly connected to the metal film 25 of the first shell 21 facing toward the side of the mounting substrate 1. Transfer pads 1311 arranged side-by-side are provided on at least the side of the connecting pattern 13 proximate to the connecting pad 11. Two transfer pads 1311 away from a right connecting pattern 13 are connected to a group of transfer pads 11 through the in-board interconnection region 12. At least one of another two transfer pads 1311 proximate to the right connecting pattern 13 is connected to the transfer pad of the right connecting pattern 13 proximate to a left connecting pattern 13 through a same in-board interconnection region 12.

A light emission wavelength of the third color chip 213 of the third color chip group 203 is greater than that of the first color chip 211 of the first color chip group 201, and a light emission wavelength of the third color chip 213 is also greater than that of the second color chip 212 of the second color chip group 202. For example, the third color chip 213 emits red laser beams, corresponding to a light emission wavelength range from 622nm to 760nm, inclusive; the first color chip 211 emits blue laser beams, corresponding to a light emission wavelength range from 435nm to 450nm, inclusive; and the second color chip 212 emits green laser beams, corresponding to a light emission wavelength range from 492nm to 577nm, inclusive.

In other embodiments, the first color chip 211, the second color chip 212, and the third color chip 213 may also emit laser beams of other colors, which is not limited herein.

Since a positioning hole needs to be provided on the mounting substrate 1, the distance between the packaging shell 22 and the positioning hole is compressed to 0.5mm, which does not meet the condition for wiring. In the present embodiment, the bottom pad 241 may be provided on the side of the packaging shell 22 proximate to the connecting pad 11. The bottom pad 241 is electrically connected to the corresponding connecting pad 11 through the transfer pad 1311 located on the side of the mounting substrate 1 proximate to the connecting pad and the in-board interconnection region 12.

In other embodiments, provided that the distance between the positioning hole and the packaging shell 22 and a distance between the packaging shells 22 meet a minimum wiring width, a bottom pad 241 may also be provided on a side of the packaging shell 22 away from the connecting pad 11. In this case, an in-board interconnection region 12 may also be provided in a region between the positioning hole and the packaging shell 22 on the mounting substrate 1, and/or in a region between the two packaging shells on the mounting substrate 1. As a result, it is possible to allow the adjacent transfer pads 1311 to be interconnected through the in-board interconnection region 12 and then electrically connected to the connecting pad 11, thereby increasing the wiring width and thus increasing the current.

For example, as shown in FIG. 9, the light-emitting apparatus includes two packaging shells 22, that is, the first shell 221 and the second shell 222, and eight connecting pads 11 are located on a same side of the two packaging shells 22. Each packaging shell 22 is provided with four bottom pads 241 on a side proximate to the connecting pads 11.

The mounting substrate 1 corresponding to the first shell 221 and the second shell 222 is as shown in FIG. 7 or FIG. 8. In order to clearly illustrate a correspondence relationship between the laser chip 21, the bottom pad 241, the transfer pad 1311 and the connecting pad 11, the transfer pads 1311 on the side of the connecting pattern 13 close to the connecting pad 11 are numbered. The transfer pads 1311 corresponding to the four bottom pads 241 of the first shell 221 are numbered 1 to 4, and the transfer pads 1311 corresponding to the four bottom pads 241 of the second shell 222 are numbered 5 to 8.

For example, the first color chip 211 emits blue laser beams, the second color chip 212 emits green laser beams, and the third color chip 213 emits red beams. The third color chip 213 is packaged in the first shell 221. The third color chip 213 is electrically connected to corresponding bottom pads 241 through the tube wall wiring 23 in the first shell 221. The bottom pads 241 are connected to corresponding transfer pads 1311 (numbered 1 and 2). The transfer pad 1311 numbered 1 is connected to the red positive polarity pad (R+) through the in-board interconnection region 12, and the transfer pad 1311 numbered 2 is connected to the red negative polarity pad (R-) through the in-board interconnection region 12.

The first color chip 211 and the second color chip 212 are packaged in the second shell 222. The first color chip 211 is electrically connected to corresponding bottom pads 241 through the tube wall wiring 23 in the second shell 222. The bottom pads 241 are connected to corresponding transfer pads 1311 (numbered 5 and 6). The transfer pad 1311 numbered 5 is connected to the blue negative polarity pad (B-) through the in-board interconnection region 12, and the transfer pad 1311 numbered 6 is connected to the blue positive pad (B+). The second color chip 212 is electrically connected to corresponding bottom pads 241 through the tube wall wiring 23 in the second shell 222. The bottom pads 241 are connected to corresponding transfer pads 1311 (numbered 7 and 8). The transfer pad 1311 numbered 7 is connected to the green positive pad (G+) through the in-board interconnect region 12, and the transfer pad 1311 numbered 8 is connected to the green negative pad (G-).

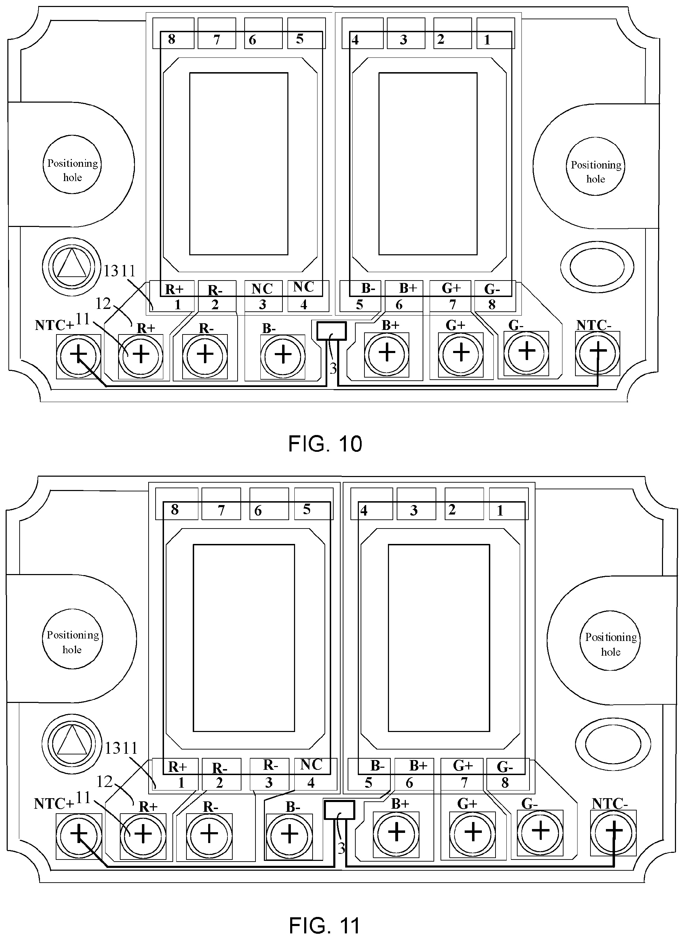

For example, as shown in FIG. 7 or FIG. 10, due to a limited wiring space and an addition of the thermistor 3, it is difficult to wire between the transfer pad 1311 (numbered 5) and the blue negative pad (B-), which would either reduce an area of other wiring or cause the wiring to overlap with the thermistor, resulting in a short circuit. As shown in FIG. 10, the blue negative polarity pad (B-) is electrically connected to the transfer pads 1311 numbered 3 and 4 and the transfer pad 1311 numbered 5 through a same in-board interconnection region 12. That is, the blue negative polarity pad (B-) is connected to the three transfer pads 1311 numbered 3, 4 and 5 through the corresponding in-board interconnection region 12. With such configuration, on one hand, the wiring width may be increased, thereby increasing the current. The higher the current, the stronger the light intensity of the laser chip 20. On the other hand, it does not affect a placement of the thermistor 3 and the connecting pads 11, making an overall structure look simple.

For example, as shown in FIG. 11, the transfer pad 1311 numbered 4 and the transfer pad 1311 numbered 5 are electrically connected to the blue negative polarity pad (B-) through a same in-board interconnection region 12. The transfer pad 1311 numbered 5 is correspondingly connected to the bottom pad 241 at the bottom of the second shell 222. The bottom pad is connected to a negative electrode of the blue laser chip, thus achieving the electrical connection between the blue laser chip and the blue negative polarity pad (B-). The transfer pad 1311 numbered 3 and the transfer pad 1311 numbered 2 are electrically connected to the red negative polarity pad (R-) through a same in-board interconnection region 12. The transfer pad 1311 numbered 2 is connected to the bottom pad 241 at the bottom of the first shell 221. The bottom pad is connected to a negative electrode of the red laser chip, thus achieving the electrical connection between the red laser chip and the red negative polarity pad (R-).

With such configuration, wiring widths of both the red negative pad (R-) and the blue negative pad (B-) may be doubled, thereby increasing the current. The higher the current, the stronger the light intensity of the laser chip 20. As a result, it does not affect the placement of the thermistor 3 and the connecting pads 11 as well, making the overall structure look simple.

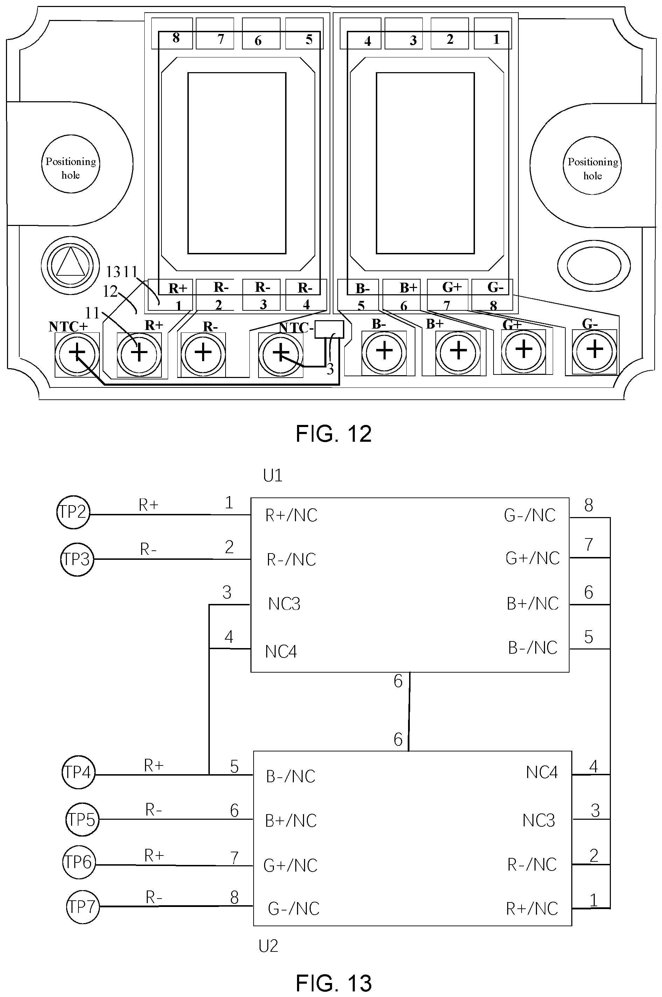

In other embodiments, considering an orientation shown in FIG. 12 as an example, with a position of the thermistor 3 as a dividing line, the red positive polarity pad (R+) and the red negative polarity pad (R-) may be disposed on a left side, and the blue negative polarity pad (B-), the blue positive polarity pad (B+), the green positive polarity pad (G+), and the green negative polarity pad (G-) each may be disposed on a right side, and substantially aligned with the bottom pads 241 of the packaging shell 22 to ensure a uniform wiring width.

In the structure, the thermistor positive polarity pad (NTC+) and the thermistor negative polarity pad (NTC-) each may be disposed on the left side (referring to FIG. 12). With such configuration, the bottom pads 241 of each packaging shell 22 may be electrically connected to an adjacent connecting pad 11. However, a wiring between the connecting pad 11 and the thermistor 3 needs to be readjusted. For example, a space under the mounting substrate 1 needs to be increased to accommodate this portion of the wiring. Alternatively, the thermistor positive polarity pad (NTC+) and the thermistor negative polarity pad (NTC-) may still be disposed on the left and right sides respectively, with different numbers of connecting pads 11 on the two sides. Either an area of the connecting pad 11 on the right side may be reduced, which may lead to a decrease in soldering reliability, or an area of the right side of the mounting substrate 1 may be increased, which is not conducive to miniaturization.

In other embodiments, if the space requirements of the thermistors are not considered, the transfer pads 1311 corresponding to various laser chips 21 may be evenly arranged and aligned with the bottom pads 241 of the packaging shell 22, which is not limited herein.

For example, FIG. 13 is a circuit diagram corresponding to the light-emitting apparatus shown in FIG. 7 or FIG. 10. In FIG. 13, U1 represents the first shell 221, and U2 represents the second shell 222. The first shell 221 and the second shell 222 have a same structure. U2 is obtained by rotating U1 clockwise by 180°. Pin 1 of U1 is connected to TP2, pin 2 is connected to TP3; pin 3, pin 4, and pin 5 of U2 are connected to TP4; pin 6 of U2 is connected to TP5, pin 7 is connected to TP6, and pin 8 is connected to TP7. Pin 1 to pin 4 of U1 correspond to four transfer pads 1311 numbered 1 to 4 respectively, pin 5 to pin 8 of U2 correspond to four transfer pads 1311 numbered 5 to 8 respectively, and TP2 to TP7 correspond to six connecting pads 11: the red positive polarity pad (R+), the red negative polarity pad (R-), the blue positive polarity pad (B+), the blue negative polarity pad (B-), the green positive polarity pad (G+), and the green negative polarity pad (G-).

Furthermore, as can be seen from the above, in a case where a plurality of packaging shells 22 are used to package different laser chip groups 20, the plurality of packaging shells 22 may adopt a same type of laser chip packaging shell. It is necessary to adjust an orientation of the packaging shell 22 according to the light-emitting type of the laser chip group 20 packaged inside. For example, FIG. 13 illustrates that the first shell 221 and the second shell 222 each are a common RGB three-color laser chip packaging shell. An orientation of the first shell 221 (i.e., U1) is such that the pins corresponding to the red laser chip 21 are adjacent to the connecting pad 11 on the mounting substrate 1. An orientation of the second shell 222 (i.e., U2) is such that the pins corresponding to the blue laser chip 21 and the green laser chip 21 are adjacent to the connecting pad 11 on the mounting substrate 1.

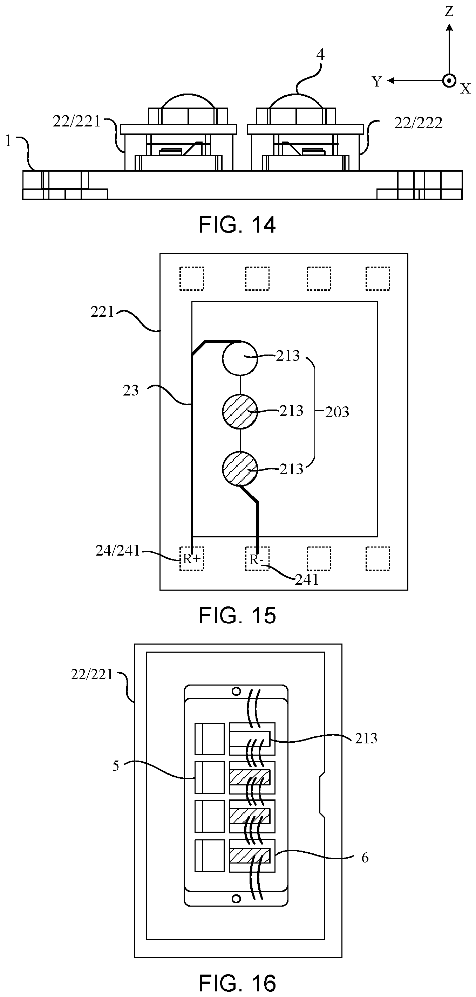

For example, as shown in FIG. 14, the light-emitting apparatus includes the first shell 221 and the second shell 222, the first shell 221 and the second shell 222 are arranged along a first direction Y. A laser chip 21 and a reflecting prism are provided in both the first shell 221 and the second shell 222. The laser chip 21 emits laser beams in the first direction Y. The laser beams are projected onto a reflecting surface of the reflecting prism and reflected. The reflected laser beams are transmitted through at least one of a light window and a lens 4.

For example, referring to FIGS. 15 to 17, a third color chip 213 is provided in the first shell 221. All third color chips 213 are connected in series. A negative electrode and a positive electrode of the third color chip 213 are connected to the bottom pads 241 provided at a bottom of the first shell 221 through the tube wall wiring 23 in the first shell 221. The bottom pad 241 is electrically connected to the transfer pad 1311 of the mounting substrate 1. The transfer pad 1311 is electrically connected to the connecting pad 11 through the in-board interconnection region 12, thereby achieving the electrical connection between the third color chip 213 and the connecting pads 11 of the mounting substrate 1. The tube wall wiring 23 in the first shell 221 may be located in the side wall and the bottom wall of the shell.

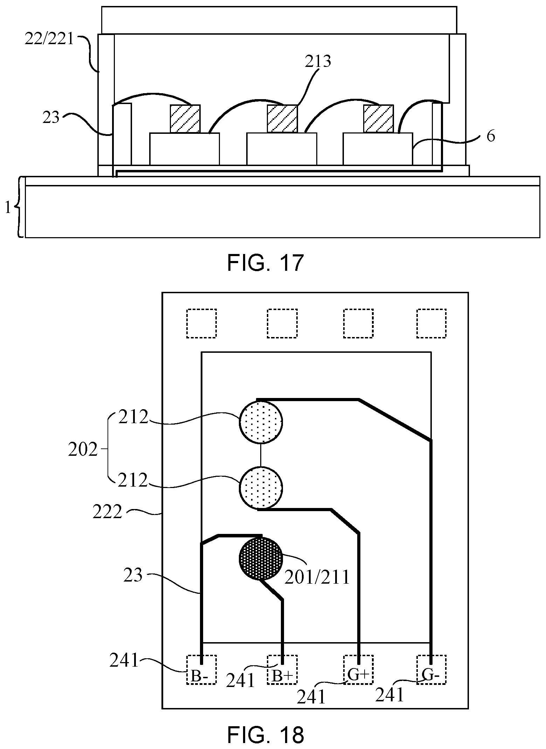

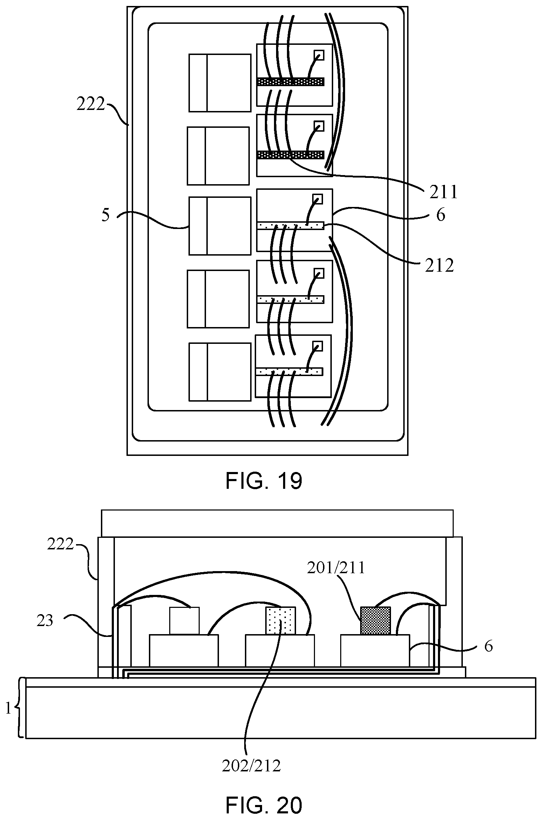

For example, referring to FIGS. 18 to 20, a first color chip 211 and a second color chip 212 are provided in the first shell 221. All first color chips 211 are connected in series, and all second color chips 212 are connected in series. There is no connection between the first color chips 211 and the second color chips 212. A positive electrode and a the negative electrode of the first color chip 211 are electrically connected to the corresponding bottom pads 241 provided at the bottom of the second shell 222 through the tube wall wiring 23 in the second shell 222. The bottom pads 241 are electrically connected to the transfer pads 1311 of the mounting substrate 1. The transfer pads 1311 are electrically connected to the corresponding connecting pads 11 through the in-board interconnection region 12, thereby achieving the electrical connection between the first color chip 211 and the connecting pads 11 of the mounting substrate 1. A positive electrode and a negative electrode of the second color chip 212 are electrically connected to the corresponding bottom pads 241 provided at the bottom of the second shell 222 through the tube wall wiring 23 in the second shell 222. The bottom pads 241 are electrically connected to the transfer pads 1311 of the mounting substrate 1. The transfer pads 1311 are connected to the corresponding connecting pads 11 through the in-board interconnection region 12, thereby achieving the electrical connection between the second color chip 212 and the connecting pads 11 of the mounting substrate 1. The tube wall wiring 23 in the second shell 222 may be located in the shell side wall and the shell bottom wall.

In other embodiments, the light-emitting apparatus may further include other components known to those skilled in the art, such as the reflective prism 5, a heat sink substrate 6, the light window (or sealing glass), and the lens 4, which are not limited herein.

In some embodiments, as shown in FIGS. 22 to 25, each packaging shell 22 is provided with a single laser chip group 20 of a single light-emitting color, and an arrangement direction of the packaging shells 22 is same as an arrangement direction of the electrical connecting portions 11. Each packaging shell 22 is provided with at least two bottom pads 241 arranged side by side on a side close to the electrical connecting portions 11; two bottom pads 241 of each packaging shell 22 are correspondingly connected to a single group of electrical connecting portions 11.

In other words, each packaging shell 22 is provided with a single laser chip 21 of a single color, and on the side of the packaging shell 22 facing toward the mounting substrate 1, each packaging shell 22 is provided with at least two bottom pads 241 arranged side by side on the side proximate to the connecting pads 11.

In the present embodiment, the light-emitting apparatus includes three packaging shells 22. A laser chip 21 of a color is packaged in a single packaging shell 22 separately, that is, the laser chips 21 in each packaging shell 22 emit laser beams of a same color. The plurality of laser chips 21 are connected in series. That is, all first color chips 211 are disposed in a same packaging shell 22 and are connected in series; all second color chips 212 are disposed in a same packaging shell 22 and are connected in series; and all third color chips 213 are disposed in a same packaging shell 22 and are connected in series. The connecting pads 11 are located on a same side of the three packaging shells 22, and the connecting pads 11 and the packaging shells 22 are arranged in a same direction. Each packaging shell 22 is provided with two bottom pads 241 on the side proximate to the connecting pads 11, and an arrangement direction of the two bottom pads 241 is same as that of the connecting pads 11; the two bottom pads 241 of each packaging shell 22 are electrically connected to a corresponding group of connecting pads 11.

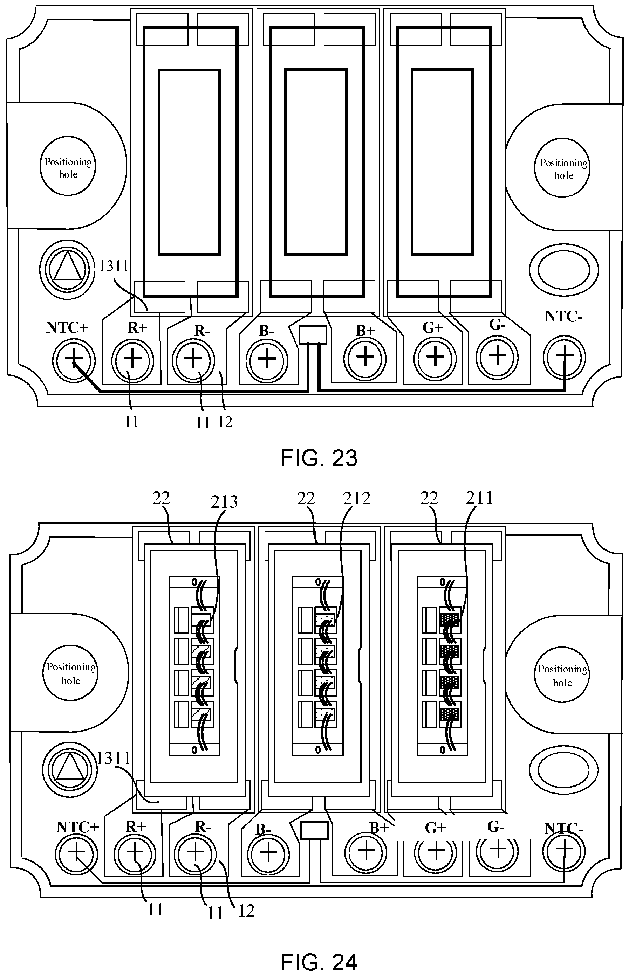

Referring to FIG. 23, the mounting substrate 1 includes three connecting patterns 13 corresponding to the three packaging shells 22 respectively. A side of each connecting pattern 13 proximate to the connecting pad 11 is provided with two transfer pads 1311 arranged side-by-side. Each transfer pad 1311 is electrically connected to the corresponding connecting pad 11 through the in-board interconnection region 12. The transfer pads 1311 are connected to the bottom pads 241 of the packaging shell 22 respectively. The bottom pads 241 are electrically connected to the laser chip 21 located in the packaging shell 22 through the tube wall wiring 23 in the packaging shell 22, thereby achieving the electrical connecting between the laser chip 21 and the corresponding connecting pad 11.

For example, as shown in FIG. 23, the packaging shell 22 located on a left side is used to package the red laser chip 21, and the corresponding two bottom pads 241 are connected to the red positive polarity pad (R+) and the red negative polarity pad (R-) respectively through the transfer pads 1311 and the in-board interconnection regions 12. The packaging shell 22 located on a middle is used to package the blue laser chip 21, and the corresponding two bottom pads 241 are connected to the blue negative polarity pad (B-) and the blue positive polarity pad (B+) respectively through the transfer pads 1311 and the in-board interconnection regions 12. The packaging shell 22 located on a right side is used to package the green laser chip 21, and the corresponding two bottom pads 241 are connected to the green positive polarity pad (G+) and the green negative polarity pad (G-) respectively through the transfer pads 1311 and the in-board interconnection regions 12.

In other embodiments, bottom pads 241 may also be provided on both the side of the packaging shell 22 proximate to the connecting pad 11 and a side away from the connecting pad 11. Correspondingly, transfer pads 1311 may be provided on both the side of the mounting substrate 1 proximate to the connecting pad 11 and a side away from the connecting pad 11. Under a condition that the distance between the positioning hole and the packaging shell 22 and the distance between the packaging shells 22 meet the minimum wiring width, an in-board interconnection region 12 may be provided on at least one of the following: a position between the positioning hole and the packaging shell 22, and, a position between the packaging shells 22; the transfer pads 1311 on a side away from the connecting pad 11 may be electrically connected to the transfer pads 1311 on a side proximate to the connecting pad 11, so as to increase the wiring width and thereby increasing the current passing through.

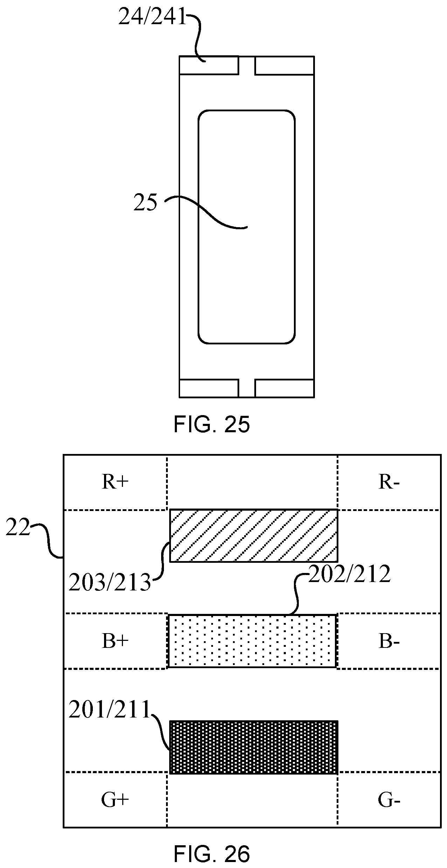

In some embodiments, as shown in FIGS. 26 to 30, a laser chip group 20 with three light-emitting colors is provided in the packaging shell 22, that is, laser chips 21 with three colors are provided in the packaging shell 22. The packaging shell 22 is provided with at least four bottom pads 241 arranged side by side on a first side proximate to the connecting pads 11, and is provided with one bottom pad 241 on a second side and a third side that are adjacent to the first side, the second side and the third side are arranged opposite to each other. The six bottom pads 241 of the packaging shell are connected to the three groups of connecting pads 11, respectively.

In the present embodiment, the laser chips 21 with three colors (i.e., the first color chip 211, the second color chip 212 and the third color chip 213) are packaged in the same packaging shell 22.

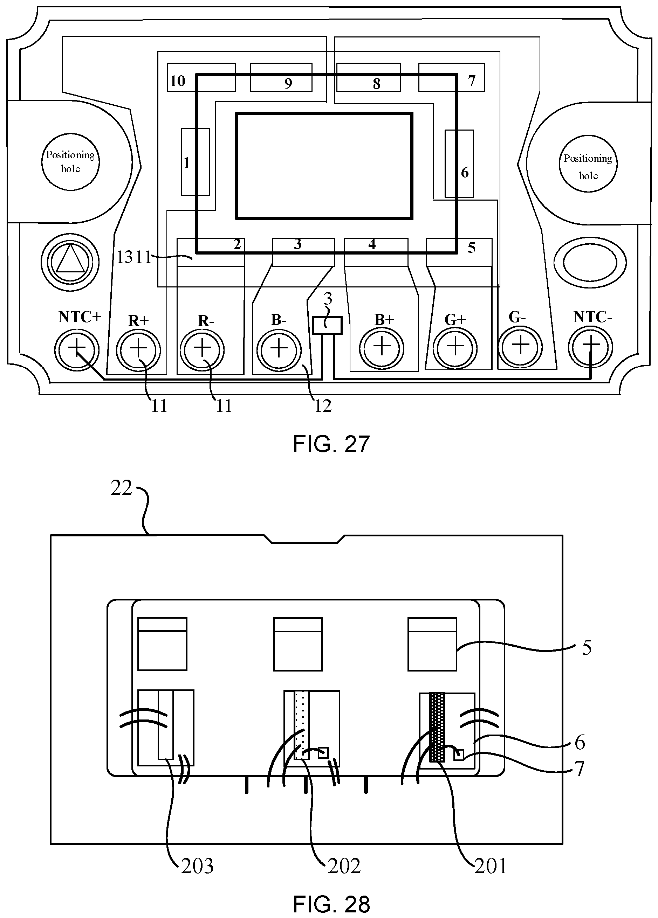

For example, as shown in FIG. 28, the first color chip 211, the second color chip 212 and the third color chip 213 are located in the same packaging shell 22. The laser chips 21 of three colors are arranged in a row from left to right and are led into an interior of the packaging shell 22 through gold wires respectively and electrically connected to the tube wall wiring 23 of the packaging shell 22.

Assuming that the third color chip 213 is a red laser chip, the first color chip 211 is a blue laser chip, and the second color chip 212 is a green laser chip, the blue laser chip and the green laser chip each need to be provided with an anti-static device 7, while a material of the red laser chip has a stronger anti-static capability, so the red laser chip is not provided with the anti-static device 7.

It should be noted that the light-emitting apparatus further includes the reflective prism 5 and the heat sink substrate 6. The laser chip group 20 and the anti-static device 7 are disposed on an upper side of the heat sink substrate 6. The reflective prism 5 is located on a light-emitting side of the laser chip group 20, and the reflective surface of the reflective prism 5 is aligned and matched with the laser chip group 20. The laser chip groups 20 may be provided with the heat sink substrates 6 respectively. Alternatively, a plurality of laser chip groups 20 with the same emitting color may be provided on a same heat sink substrate 6, which is not limited herein.

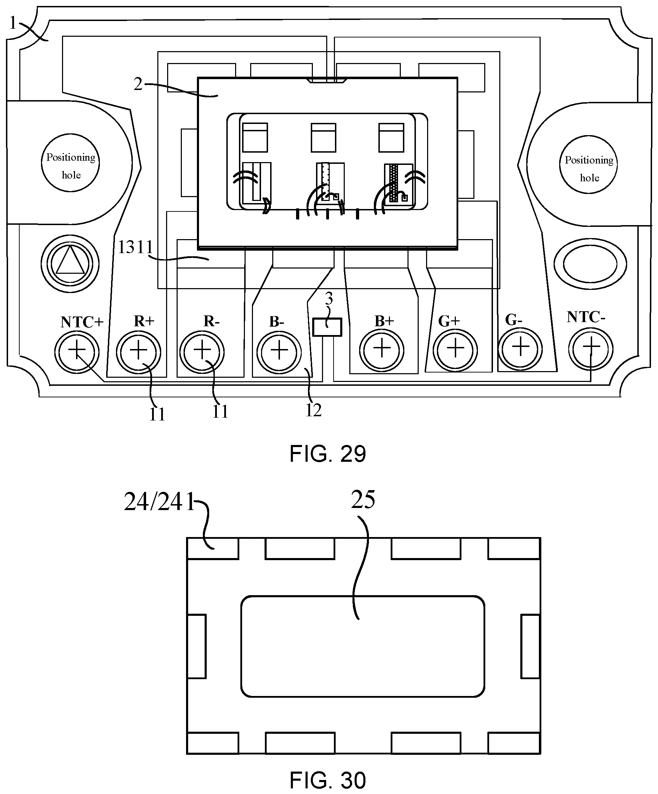

For example, as shown in FIGS. 29 to 30, a side of the packaging shell 22 close to the connecting pad 11 is the first side, the second side and the third side are located on a left side and a right side of the first side respectively, and are adjacent to the first side. Four bottom pads 241 are arranged side by side on the first side of the packaging shell 22, one bottom pad 241 is arranged on the second side, and one bottom pad 241 is arranged on the third side.

Correspondingly, as shown in FIG. 27, the mounting substrate 1 includes the connecting pattern 13, connecting pads 11, and the in-board interconnection regions 12. The connecting pattern 13 is provided with four transfer pads 1311 on the side close to the connecting pads 11 (corresponding to the first side of the packaging shell 22), and one transfer pad 1311 on each of the left side and the right side (corresponding to the second side and the third side of the packaging shell 22). The six transfer pads 1311 are connected to the six bottom pads 241 respectively. The transfer pads 1311 are electrically connected to the corresponding connecting pads 11 through the in-board interconnection regions 12, thus the six bottom pads 241 are connected to the six connecting pads 11 corresponding to each other, and the connecting relationship is as follows. The bottom pad 241 on the second side (considering the left side as an example) is electrically connected to the transfer pad 1311 numbered 1, and the transfer pad 1311 numbered 1 is electrically connected to the red positive polarity pad (R+) through an in-board interconnection region 12. Optionally, at least one of the transfer pads 1311 numbered 9 and 10 and the transfer pad 1311 numbered 1 may be electrically connected to the red positive polarity pad (R+) through a same in-board interconnection region 12. A first bottom pad 241 on a left end of the first side is electrically connected to the transfer pad 1311 numbered 2. The transfer pad 1311 numbered 2 is electrically connected to the red negative polarity pad (R-) through an in-board interconnect region 12. A second bottom pad 241 on the left side of the first side is electrically connected to the transfer pad 1311 numbered 3, and the transfer pad 1311 numbered 3 is electrically connected to the blue negative polarity pad (B-) through an in-board interconnect region 12. A second bottom pad 241 on a right side of the first side is electrically connected to the transfer pad 1311 numbered 4, and the transfer pad 1311 numbered 4 is electrically connected to the blue positive polarity pad (B+) through an in-board interconnect region 12. A first bottom pad 241 on the right side of the first side is electrically connected to the transfer pad 1311 numbered 5. The transfer pad 1311 numbered 5 is electrically connected to the green positive polarity pad (G+) through an in-board interconnection region 12. The bottom pad 241 on the third side (considering the right side as an example) is electrically connected to the transfer pad 1311 numbered 6. The transfer pad 1311 numbered 6 is electrically connected to the green negative polarity pad (G-) through an in-board interconnection region 12. Optionally, at least one of the transfer pads 1311 numbered 7 and 8 and the transfer pad numbered 6 may also be electrically connected to the green negative polarity pad (G-) through a same in-board interconnection region 12.

In other embodiments, the red positive polarity pad (R+) may also be connected to at least one of the transfer pads 1311 numbered 1, 10 and 9 through an in-board interconnection region 12. Similarly, the green negative polarity pad (G-) may be connected to at least one of the transfer pads 1311 numbered 6, 7 and 7 through an in-board interconnection region 12. The connection manner may be provided according to the relative position and size of the mounting substrate 1, the packaging shell 22 and the positioning hole, and is not limited herein.

In some embodiments, as shown in FIG. 29 to FIG. 30, the packaging shell 22 further includes a fourth side disposed opposite to the first side, and the fourth side is provided with four bottom pads 241 arranged side by side. Two of the bottom pads 241 on the fourth side are connected to the bottom pad 241 on the second side through a same in-board interconnection region 12, and another two bottom pads 241 are connected to the bottom pad 241 on the third side through a same in-board interconnection region 12.

In the present embodiment, the fourth side of the packaging shell 22 is a side of the packaging shell 22 away from the connecting pad 11. Four bottom pads 241 are also provided on the side. Correspondingly, as shown in FIG. 27, four transfer pads 1311 (numbered 7 to 10) are also provided on a side of the connecting pattern 13 away from the connecting pad 11. The four transfer pads 1311 are connected to the four bottom pads on the fourth side of the packaging shell 22, respectively. The two transfer pads 1311 numbered 9 and 10 are electrically connected to the transfer pad 1311 (numbered 1) located on the left side of the connecting pattern 13, so that the three transfer pads 1311 numbered 1, 9 and 10 are electrically connected to the red positive polarity pad (R+) through a same in-board interconnection region 12, thereby enabling the two bottom pads 241 on the fourth side of the packaging shell 22 to be connected to the bottom pad 241 on the second side through the same in-board interconnection region 12. The two transfer pads 1311 numbered 7 and 8 are connected to the transfer pad 1311 (numbered 6) located on the right side of the connecting pattern 13, so that the three transfer pads 1311 numbered 6, 7 and 8 are electrically connected to the green negative polarity pad (G-) through a same in-board interconnection region 12.

With such configuration, the red positive polarity pad (R+) and the green negative polarity pad (G-) each are connected to the three transfer pads 1311, thus enabling the two bottom pads 241 on the fourth side of the packaging shell 22 to be connected to the bottom pad 241 on the third side through the same in-board interconnection region 12. In this way, it is possible to increase a width of the in-board interconnection region 12, which is conducive to increasing the current.

It should be noted that FIG. 27 and FIG. 29, by way of example, show that the transfer pads 1311 on the side of the mounting substrate 1 away from the connecting pads 11 are arranged in two groups. That is, the connecting pads 1311 numbered 9 and 10 are one group and the connecting pads 1311 numbered 7 and 8 are another group, which are electrically connected to transfer pads 1311 numbered 1 and 6 respectively. However, it does not constitute a limitation on the light-emitting apparatus provided in the embodiments of the present disclosure.

In other embodiments, at least one of the four transfer pads 1311 may be electrically connected to the transfer pad 1311 numbered 1, and at least one of remaining transfer pads 1311 may be electrically connected to the transfer pad 1311 numbered 6. For example, the transfer pads 1311 numbered 8, 9, and 10 may be electrically connected to the transfer pad 1311 numbered 1, and the transfer pad 1311 numbered 7 may be electrically connected to the transfer pad 1311 numbered 6. Alternatively, the transfer pad 1311 numbered 10 may be electrically connected to the transfer pad 1311 numbered 1, and the transfer pads 1311 numbered 7, 8, and 9 may be electrically connected to the transfer pad 1311 numbered 6. Alternatively, the four transfer pads 1311 numbered 7 to 10 may be electrically connected to the transfer pad 1311 numbered 1 and the transfer pad 1311 numbered 6, which is not limited herein.

Based on the above embodiments, the present disclosure further provides a laser projection device, the laser projection device includes any one of the above-mentioned light-emitting apparatuses and has corresponding beneficial effects. To avoid repetition, the present disclosure will not be repeated herein.

For example, the laser projection device includes: a light-emitting apparatus and a driving circuit. The light-emitting apparatus is any light-emitting apparatus as described above, and a number of driving circuits is consistent with a number of laser chip groups 20 in the light-emitting apparatus. A positive electrode connecting portion 111, which is connected to the laser chip group 20, is electrically connected to a positive electrode of a corresponding driving circuit, and a negative electrode connecting portion 112, which is connected to the laser chip group 20, is electrically connected to a negative electrode of the corresponding driving circuit. The driving circuit involved herein is an optical driving circuit 006 described below.

The laser projection device may include a laser TV and a laser projector, as well as other laser projection devices that may be conceived by those skilled in the art, which are not limited herein.

Based on the laser projection device mentioned above, embodiments of the present disclosure provides an exemplary description of a structural layout, a working method, and an application scenario of the laser projection device.

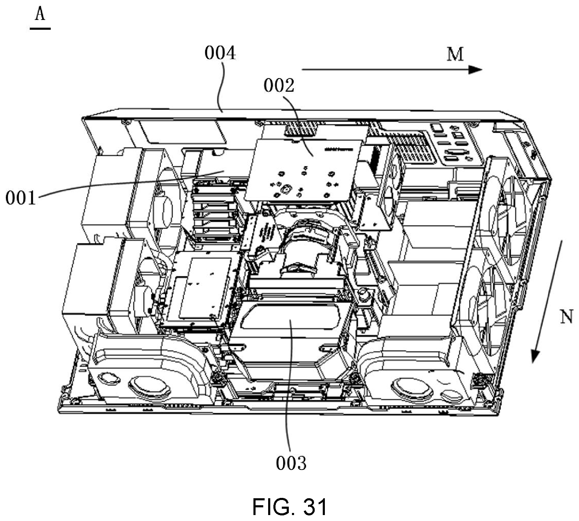

FIG. 31 is a schematic diagram of an exemplary laser projection device. Referring to FIG. 31, the laser projection device A includes a laser source 001, a light modulation assembly 002, and a projection lens 003. The laser projection device A further includes a housing 004 (a portion of the housing 004 being shown in FIG. 31).

The laser source 001 is configured to provide illumination beams (e.g., laser beams). The optical modulation assembly 002 is configured to modulate the illumination beams provided by the laser source 001 with image signals to obtain projection beams. The projection lens 003 is configured to project the projection beams into an image on a screen or a wall. The laser source 001, the light modulation assembly 002, and the projection lens 003 may be assembled in the housing 004. The laser source 001, the light modulation assembly 002, and the projection lens 003 may be sequentially connected in a propagation direction of beams.

The laser source 001, the optical modulation assembly 002, and the projection lens 003 may be wrapped by corresponding housings. The housings of the laser source 001, the light modulation assembly 002, and the projection lens 003 may support their corresponding optical components, respectively, and make the optical components meet certain sealing or airtight requirements.

An end of the light modulation assembly 002 is connected to the projection lens 003, and the light modulation assembly 002 and the projection lens 003 are arranged in an exit direction (e.g., paralleling to a direction N) of the projection beams of the laser projection device 1000. Another end of the optical modulation assembly 002 is connected to the laser source 001.

In some embodiments, an arrangement direction of the laser source 001 and the light modulation assembly 002 is approximately perpendicular to an arrangement direction of the light modulation assembly 002 and the projection lens 003. That is, in the laser projection device A, an exit direction of the projection beams (e.g., paralleling to the direction N) is approximately perpendicular to an exit direction of the illumination beams (e.g., paralleling to a direction M). On one hand, the connection structure may adapt to optical path characteristics of a reflective light valve in the optical modulation assembly 002, and on the other hand, it is conducive to shortening a length of the optical path in a certain direction, so that there is more space to arrange the various components of the laser projection device A.

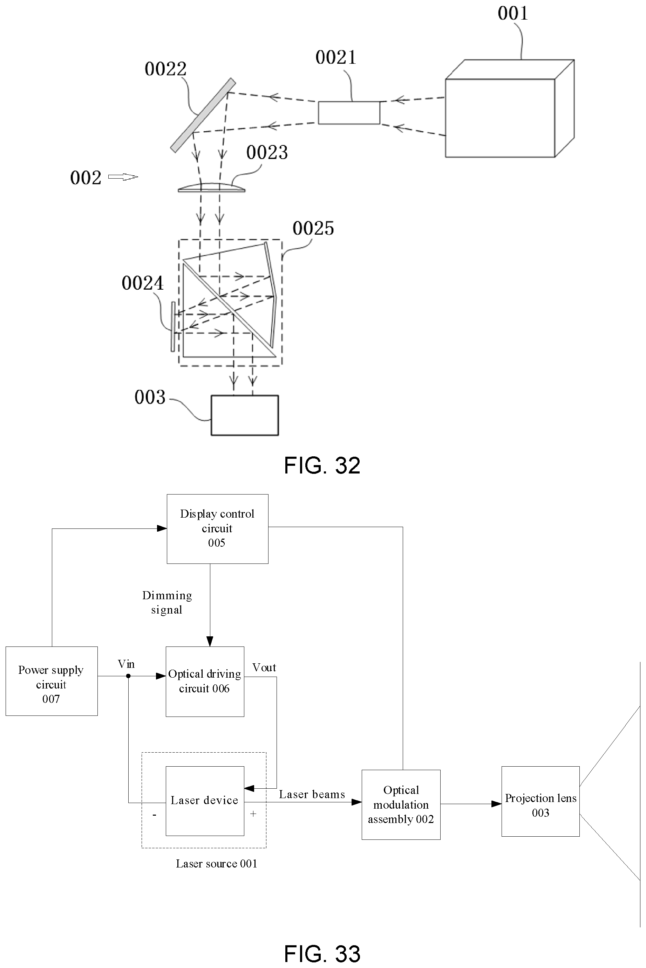

For example, FIG. 32 is a schematic diagram of the projection imaging optical path of the laser projection device. As described above, the laser projection device A includes the laser light source 001, the optical modulation assembly 002, and the projection lens 003. Referring to FIG. 32, the illumination beams emitted by the laser source 001 enter the optical modulation assembly 002.

The laser source 001 includes the light-emitting apparatus mentioned above. In some examples, the light-emitting apparatus may emit blue laser beams, and the laser source 001 may further include a wavelength conversion device used to generate other primary colors besides blue due to excitation of the blue laser beams, which are jointly used to form the illumination beams. In other examples, the laser source 001 includes a three color light-emitting apparatus, that is, a three color laser assembly. The three color laser assembly is used to emit laser beams of three colors, in this case, there is no need to provide the wavelength conversion device. Furthermore, the laser beams of three colors have a wide color gamut and high brightness, enabling the laser source 001 to provide high-quality illumination beams.

As shown in FIG. 32, the light modulation assembly 002 includes a light homogenizing component 0021, a reflector 0022, a lens 0023, a light valve 0024, and a prism component 0025. The light valve 0024 is configured to modulate the illumination beams incident upon it into projection beams according to an image signal, and direct the projection beams to the projection lens 003. The light homogenizing component 0021 and the light valve 0024 are arranged sequentially along a propagation direction of the beams. The light homogenizing component 0021 is configured to homogenize the illumination beams incident upon it and direct the homogenized illumination beams toward the light valve 0024.

In some embodiments, the light homogenizing component 0021 includes a light pipe. The light pipe may receive the illumination beams provided by the laser source 001 and homogenize the illumination beams. In some embodiments, a light outlet of the light pipe is in a shape of a rectangle. The light pipe may reshape a beam spot of the beams, so that a shape of the beam spot matches a shape of the light valve. In some embodiments, the light homogenizing component 0021 may also be a fly-eye lens.

The light valve 0024 may be a reflective light valve. The light valve 0024 may include a plurality of reflective plates, and each of the plurality of reflective plates may correspond to a pixel in a projection image. For example, depending on the projected image to be displayed, a reflective plate corresponding to a pixel that needs to be displayed in a bright state in the plurality of reflective plates of the light valve 0024 may reflect the beams to the projection lens 003, and the beams reflected to the projection lens 003 are called the projection beams. In this way, the light valve 0024 may modulate the illumination beams to obtain the projection beams, and achieve the display of the image through the projection beams.

In some examples, the light valve 0024 is a digital micromirror device (DMD) 240. The digital micromirror device includes a plurality of (e.g., thousands of) micromirrors that may be individually driven to rotate. The plurality of micromirrors 251 may be arranged in an array. One micromirror (e.g., each micromirror) corresponds to one pixel in the projection image to be displayed.

Referring to FIG. 32, in some embodiments, the light modulation assembly 002 of the laser projection device A may further include an illumination lens group located between the light valve 0024 and the light homogenizing component 0021, and the illumination lens group includes the reflector 0022, the lens 0023 and the prism assembly 0025. The laser beams homogenized by the light homogenizing component 0021 may be incident on the light valve 0024 through the illumination lens group.

The illumination beams exit from the light homogenizing component 0021 are directed toward the reflective mirror 0022, and the reflective mirror 0022 then reflects the illumination beams incident upon it to the convex lens 0023. The convex lens 0023 focuses the illumination beams incident upon it to the prism assembly 0025, and the prism assembly 0025 reflects the illumination beam incident upon it to the light valve 0024.

FIG. 33 illustrates a schematic diagram of a circuit control principle of the laser projection device involved in the embodiments of the present disclosure. As shown in FIG. 33, a display control circuit 005 is connected to a multimedia signal board at a front end (which may also be referred to as a system SOC board, used to decode audio and video streams), after a video signal is received, the display control circuit 005 may further process the video signal (e.g., geometric correction processing) and generate a dimming signal based on the processed video signal.

The display control circuit 005 is connected to an optical driving circuit 006, in this way, the display control circuit 005 can transmit a dimming signal to the optical driving circuit 006.

The dimming signal may include an analog dimming (Adim) signal and a pulse width modulation (PWM) signal.

The PWM signal is used to control a presence or absence of a driving current transmitted to the laser source 001, and the Adim signal in the dimming signal is used to control a magnitude of the driving current.

The optical driving circuit 006 may also be referred to as a laser driving circuit, which is a direct current-direct current (DC-DC) conversion circuit. For example, the optical driving circuit 006 may be a boost circuit or a buck circuit.

The optical driving circuit 006 is used to receive the dimming signal and a power supply input voltage of the power supply circuit 007, and based on the dimming signal, converts the input power supply input voltage into a power supply output voltage, thereby outputting a driving current to the laser source.

The laser source 001 emits laser beams due to the driving of the driving current and transmits the laser beams to the optical modulation assembly 002.

The laser source 001 may include at least one light-emitting apparatus (referred to as the laser device in FIG. 33) as described above in the embodiments of the present disclosure. The laser beams emitted by the at least one light-emitting apparatus may be of the same or different colors.

Laser source 001 includes a multicolor laser device. For example, the multicolor laser device may be a two-color laser device including a red laser device and a blue laser device. Alternatively, the multicolor laser device may be a three-color laser device including a red laser device, a blue laser device and a green laser device. A number of light-driving circuits 006 are consistent with a number of laser chip groups 20 in the light-emitting apparatus, and the light-driving circuits 006 correspond to the laser chip groups 20, respectively.

For example, the laser source 001 includes a red laser chip group 20, a blue laser chip group 20 and a green laser chip group 20. In this case, the projection device includes a red light driving circuit 006_R, a green light driving circuit 006_G, and a blue light driving circuit 006_B, which are electrically connected to the laser chip groups 20 of the corresponding colors, respectively.

The aforementioned three-color laser source 001 can emit red laser beams, green laser beams, and blue laser beams respectively when driven by the driving current. Based on the principle of color synthesis in optics, it is known that white beams can be obtained by combining and homogenizing the beams of the three colors.

Referring to FIG. 33, the laser beams emitted by the laser source 001 are transmitted to the optical modulation assembly 002. The optical modulation assembly 002 integrates a digital micromirror device (DMD) and a DMD driving circuit. DMD is a core optical modulation device of the optical modulation assembly 002. The DMD driving circuit is used to drive the DMD to work based on the video signal. In this way, the DMD is used to modulate the laser beams emitted by the laser source 001 due to the control of the DMD driving circuit to obtain the image to be projected and displayed.

For example, the DMD receives a driving control signal corresponding to an image signal, flips the thousands of tiny reflective mirrors on its surface at a positive angle or a negative angle corresponding to the driving signal, and forms the laser beams illuminating its surface into an image to be projected and displayed, and reflects the image into the projection lens.

The light modulation assembly 002 transmits the image to be projected and displayed to the projection lens, and the projection lens can magnify the image to be projected and displayed and project the image to be projected and displayed onto a target object in a manner of beams. The target object may be the projection screen or the wall.

The projection lens may be an ultra-short-focus projection lens, which is used to project image beams onto the projection screen, thereby achieving the display of a projected image.

In some examples, the laser projection device involved in the embodiments of the present disclosure may be the ultra-short-focus laser projection device.

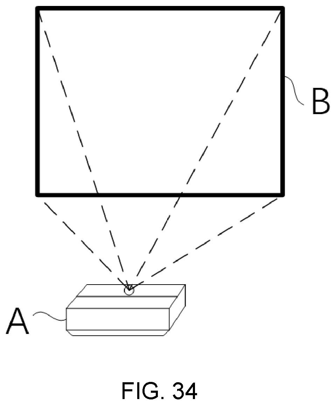

Any one of the laser projection devices described above in the embodiments of the present disclosure may be applied to a projection system. FIG. 34 illustrates a projection system. As shown in FIG. 34, the projection system includes the laser projection device A and a projection screen B, and the projection screen B displays an image transmitted by the laser projection device A.

Finally, it should be noted that, the above-mentioned embodiments are merely used to illustrate the technical solution of the present disclosure, rather than being a limitation on it. Although the present disclosure are described in detail with reference to each of the foregoing embodiments, a person of ordinary skill in the art will understand that the technical solutions described in the foregoing embodiments may still be modified, or some of the technical features may be equivalently replaced, and these modifications or replacements do not deviate essences of corresponding technical solutions from the scope of the technical solutions of the embodiments of the present disclosure.

For ease of explanation, the above description has been provided in conjunction with specific embodiments. However, the above exemplary discussion is not intended to be exhaustive or to limit the implementation to the specific embodiments disclosed above. Based on the above teachings, various modifications and variations may be obtained. The selection and description of the above implementations are to better explain the principles and practical applications, so that those skilled in the art can better use the implementations and various modified implementations suitable for specific usage considerations.

## Claims

1. A light-emitting apparatus, **characterized by** comprising:
a mounting substrate (1) including a connecting pattern (13), an electrical connecting portion (11), and an in-board interconnection region (12); wherein the electrical connecting portion (11) is located on a surface of the mounting substrate (1), and the electrical connecting portion (11) is electrically connected to the connecting pattern (13) through the in-board interconnection region (12); and
a light-emitting unit (2) including a packaging shell (22) and at least two laser chip groups (20) with different light-emitting colors disposed in the packaging shell (22); wherein each laser chip group (20) includes one laser chip or more laser chips (21) connected in series, the light-emitting unit (2) is fixed to the mounting substrate (1) and the light-emitting unit (2) is electrically connected to the connecting pattern (13);
wherein the electrical connecting portion (11) is provided with a plurality of groups and corresponds to the at least two laser chip groups (20), respectively, each group of electrical connecting portions (11) includes a positive electrode connecting portion (111) and a negative electrode connecting portion (112), the positive electrode connecting portion (111) is connected to a positive electrode of a laser chip group (20) of a corresponding color, and a negative electrode connecting portion (112) is connected to a negative electrode of the laser chip group (20) of the corresponding color.

2. The light-emitting apparatus according to claim 1, wherein a plurality of light-emitting apparatuses are provided, and the plurality of groups of electrical connecting portions (11) corresponding to a laser chip group (20) of a same light-emitting color are connected in series in the plurality of light-emitting apparatuses.

3. The light-emitting apparatus according to claim 1, wherein the packaging shell (22) is provided with a conductive structure (24) on a side facing toward the mounting substrate (1), the connecting pattern (13) is further provided with a conductive region (131), the light-emitting unit (2) is fixed on the connecting pattern (13) and electrically connected to the conductive region (131), the laser chip group (20) is electrically connected to a tube wall wiring (23) of the packaging shell (22), and the tube wall wiring (23) is further electrically connected to the conductive structure (24).

4. The light-emitting apparatus according to claim 3, wherein in a direction perpendicular to a plane where the mounting substrate (1) is located, the electrical connecting portion (11) at least partially overlaps with the in-boardinterconnection region (12) , the connecting pattern (13) at least partially overlaps with the interconnection region (12) , and the conductive structure (24) at least partially overlaps with the connecting pattern (13);
in the plane where the mounting substrate (1) is located, the plurality of groups of electrical connecting portions (11) are located on a same side of the mounting substrate (1).

5. The light-emitting apparatus according to claim 4, wherein the plurality of electrical connecting portions are arranged side by side;
at least a portion of the positive electrode connection portions (111) and the negative electrode connecting portions (112) included in the plurality of groups of electrical connecting portions (11) are arranged adjacent to each other with a same polarity.

6. The light-emitting apparatus according to claim 3, wherein the conductive structure (24) includes a plurality of bottom pads (241), the connecting pattern (13) includes a plurality of transfer pads (1311), the transfer pads (1311) are electrically connected to the bottom pads (241) respectively, the bottom pads (241) are further electrically connected to the tube wall wiring (23), and the transfer pads (1311) are further electrically connected to the electrical connecting portion (11) through the in-board interconnection region (12);
the plurality of transfer pads (1311) are arranged side by side and are located at least on a side of the connecting pattern (13) proximate to the plurality of groups of electrical connecting portions (11), and a side-by-side arrangement direction of the plurality of transfer pads (1311) is same as a side-by-side arrangement direction of the plurality of groups of electrical connecting portions (11).

7. The light-emitting apparatus according to claim 6, wherein a number of the transfer pads (1311) is greater than a total number of positive electrode connecting portions (111) and negative electrode connecting portions (112) included in the plurality of groups of electrical connecting portions (11), such that a portion of the positive electrode connecting portions (111) or the negative electrode connecting portions (112) are connected to the transfer pads (1311) in a one-to-many manner.

8. The light-emitting apparatus according to any of claims 1 to 7, wherein the electrical connecting portion includes a connecting pad.

9. The light-emitting apparatus according to claim 6, wherein the laser chip groups (20) include a first color chip group (201), a second color chip group (202), and a third color chip group (203) that emit laser beams of different colors;
a light emission wavelength of the third color chip group (203) is greater than a light emission wavelength of the first color chip group (201) and a light emission wavelength of the second color chip group (202);
the packaging shell (22) includes a first shell (221) and a second shell (222) arranged side by side, the third color chip group (203) is provided in the first shell (221), and the first color chip group (201) and the second color chip group (202) are provided in the second shell (222);
each of the packaging shells (22) is provided with four bottom pads (241) arranged side by side at least on a side close to the electrical connecting portion (11); two of the bottom pads (241) of the second shell (222) are connected to one group of electrical connecting portions (11), and another two bottom pads (241) are connected to another group of electrical connecting portions (11); two of the bottom pads (241) of the first shell (221) away from the second shell (222) are connected to yet another group of electrical connecting portions (11), and at least one of another two adjacent bottom pads (241) close to the second shell (222) is connected to one bottom pad (241) of the second shell (222) close to the first shell (221) through a same in-board interconnect region (12).

10. The light-emitting apparatus according to claim 6, wherein each packaging shell (22) is provided with a laser chip group (20) of a light-emitting color, and an arrangement direction of the packaging shells (22) is same as an arrangement direction of the plurality of groups of electrical connecting portions (11);
each packaging shell (22) is provided with at least two bottom pads (241) arranged side by side on a side proximate to the electrical connecting portions (11); two bottom pads (241) of each packaging shell (22) are correspondingly connected to one group of electrical connecting portions (11) respectively.

11. The light-emitting apparatus according to claim 6, wherein the laser chip groups (20) with three light-emitting colors are provided in the packaging shell (22);
the packaging shell (22) is provided with at least four bottom pads (241) arranged side by side on a first side proximate to the electrical connecting portion (11), and one bottom pad (241) is provided on each of a second side and a third side adjacent to the first side, the second side and the third side are arranged opposite to each other; the six bottom pads (241) of the packaging shell (22) are respectively connected to three groups of electrical connecting portions (11).

12. The light-emitting apparatus according to claim 11, wherein the packaging shell (22) further includes a fourth side disposed opposite to the first side, and the fourth side is provided with four bottom pads (241) arranged side by side;
two of the bottom pads (241) on the fourth side are connected to the one bottom pad (241) on the second side through a same in-board interconnection region (12), and another two bottom pads (241) are connected to the one bottom pad (241) on the third side through a same in-board interconnection region (12).

13. The light-emitting apparatus according to claim 4, wherein in the plane where the mounting substrate (1) is located, a width of a single side of the electrical connecting portion (11) is any value range from 1.3 mm to 1.7 mm, inclusive;
along an arrangement direction of the electrical connecting portion (11), a distance between adjacent electrical connecting portions (11) is any value range from 0.8mm to 1.2mm, inclusive.

14. The light-emitting apparatus according to any one of claims 1 to 13, wherein the light-emitting apparatus further comprises: a thermistor (3), and the mounting substrate (1) has one group of electrical connecting portions (11) corresponding to the thermistor (3);
two ends of the thermistor (3) are electrically connected to a positive electrode connecting portion (111) and a negative electrode connecting portion (112) of the corresponding group of electrical connecting portions (11), respectively.

15. The light-emitting apparatus according to claim 14, wherein the thermistor (3) is located between the plurality of groups of electrical connecting portions (11) and the at least two laser chip groups (20), and the plurality of groups of electrical connecting portions (11) are symmetrically arranged on two sides of the thermistor (3).

16. A laser projection device, **characterized by** comprising:
a light-emitting apparatus, the light-emitting apparatus being the light-emitting apparatus according to any one of claims 1 to 15;
a driving circuit, a number of driving circuits being consistent with a number of laser chip groups (20) in the light-emitting apparatus;
the positive electrode connecting portion (111) connected to the laser chip group (20) is electrically connected to a positive electrode of a corresponding driving circuit, and the negative electrode connecting portion (112) connected to the laser chip group (20) is electrically connected to the negative electrode of the corresponding driving circuit.
